# EUROPEAN PATENT SPECIFICATION

(11) **EP 2 603 844 B1**
(45) Date of publication and mention of the grant of the patent: **20.05.2020**
(21) Application number: 10855771.1
(22) Date of filing: 12.08.2010
(51) Int. Cl.: G06F 3/033, G06F 3/00

(54) **FINGER IDENTIFICATION ON A TOUCHSCREEN**
FINGERIDENTIFIZIERUNG AUF EINEM TOUCHSCREEN
IDENTIFICATION DE DOIGTS SUR UN ÉCRAN TACTILE

(43) Date of publication of application: 19.06.2013
(73) Proprietor: Google LLC, Mountain View, CA 94043 (US)
(72) Inventor: WU, Genqing, Beijing 100085 (CN); SU, Hua, Beijing 100084 (CN)
(74) Representative: Derry, Paul Stefan
(86) International application number: PCT/CN2010/075930
(87) International publication number: WO 2012/019350

(56) References cited:
- WO-A1-03/017244
- CN-A- 1 759 369
- CN-A- 101 118 476
- DE-U1-202008 000 261
- JP-A- 2007 179 502
- US-A1- 2008 042 979
- US-A1- 2008 316 181
- US-A1- 2009 287 999

## Description

### TECHNICAL FIELD

This document generally describes techniques, methods, devices, and systems for identifying a finger or a type of finger on a touchscreen.

### BACKGROUND

Many mobile computing devices (e.g., cell phones, smart phones, personal digital assistants (PDA), portable media players, etc.) include touchscreens for presenting information graphically to a user and for receive input from physical contact by the user, such as by a user's fingertips. A touchscreen is a graphical display that includes sensors (e.g., capacitive touch sensors) that are capable of detecting when and where a user touches the touchscreen. With a touchscreen, a user can provide input to a mobile computing device by touching graphical elements (e.g., icons, keys, etc.) displayed on the touchscreen. For example, when a keyboard is displayed on a touchscreen, a user can type "hello world" by touching the corresponding keys on the displayed keyboard using his/her fingers.

DE202008000261 discusses a method for performing multi-touch (MT) data fusion in which multiple touch inputs occurring at about the same time are received to generating first touch data.

US2008/316181 discusses a device with a housing that has a substantial portion covered by a touch sensitive surface.

### SUMMARY

The present invention is defined by method claim 1 and system claim 12. This document describes techniques, methods, devices, and systems for identifying a finger or a type of finger on a touchscreen, and for interpreting input based on the identified finger or type of finger. For example, in response to receiving input indicating that a user has touched a touchscreen of a mobile computing device, a particular finger or type of finger can be identified as having provided the input. Various information associated with the user touching the touchscreen can be used to identify the particular finger or type of finger, such as a position of the mobile computing device with respect to the user (e.g., how the user is holding the device), a contact area associated with the touch input, and a level of pressure associated with the touch input.

The touch input can be interpreted based on the identified finger or type of finger. For example, if the user touches a particular icon displayed on the touchscreen with his/her index finger, a first action may be performed with respect to the particular icon (e.g., run an application corresponding to the icon). However, if the user touches the particular icon with his/her thumb, a second action may be performed instead (e.g., display a menu of options associated with the icon and/or the application). Also, the accepted position of the input can be adjusted based on the identified finger or type of finger. For example, a device may determine - either from data for multiple users or usage data over time for a particular user - that a particular finger misses a particular key or keys in a particular direction each time a users presses the key or keys, perhaps because the user holds the device so that they are not looking straight on at the screen.

In one implementation, a computer-implemented method includes receiving, at a mobile computing device, a first input that indicates a user touched a touchscreen display of the mobile computing device with a pointer, and determining a position of the mobile computing device with respect to the user based on information other than information from the user's touching of the touchscreen display. The method also includes identifying the pointer as a particular finger or type of finger of the user based upon, at least, the determined position of the mobile computing device with respect to the user, and interpreting the received first input on the touchscreen display of the mobile computing device using the identified finger or type of finger.

In another implementation, a system for interpreting touchscreen input on a mobile computing device includes a mobile computing device and a touchscreen display of the mobile computing device that is configured to receive input that indicates a user touched the touchscreen display with a pointer. The system also includes a position extraction module of the mobile computing device that is configured to determine a position of the mobile computing device with respect to the user based on information other than information from the user's touching of the touchscreen display. The system further includes means for identifying the pointer as a particular finger or type of finger of the user based on, at least, the determined position of the mobile computing device with respect to the user. The system additionally includes an input interpreter of the mobile computing device that is configured to interpret the received input on the touchscreen display of the mobile computing device using the particular finger or type of finger identified by the means for identifying.

In another implementation, a computer-implemented method includes receiving, at a mobile computing device, a first input that indicates a user touched a touchscreen of the mobile computing device with a pointer, and identifying the first input as corresponding to a particular graphical element displayed on the touchscreen based on the first input and offset information associated with the particular graphical element. In the method, offset information associated with a graphical element indicates a distance and direction by which an input area for the graphical element is offset from a location at which the graphical element is displayed on the touchscreen. In the method, an input area for a graphical element includes an area within which received input is registered by the mobile computing device as corresponding to the graphical element. The method further includes performing an action on the mobile computing device associated with the particular graphical element and, after performing the action, determining whether the user intended for the first input to correspond to the particular graphical element based on second input received at the mobile computing device from the user. The method additionally includes adjusting the offset information associated with the particular graphical element based on the determination of whether the user intended for the first input to correspond to the particular graphical element.

Particular embodiments can be implemented, in certain instances, to realize one or more of the following advantages. Fingers or types of fingers providing touch input on a touchscreen can be readily identified. Accuracy of touch input on a touchscreen can be increased by correcting for positional touch bias associated with the particular finger or type of finger that is providing the touch input. The range of actions that a user can instruct a touchscreen device to perform based on touch input can increase by associating actions with particular fingers or types of fingers. Finger models can be continually improved and refined during normal operation of the mobile computing device by monitoring input provided after a particular finger or type of finger has been identified as having touched the touchscreen.

The details of one or more embodiments are set forth in the accompanying drawings and the description below. Other features, objects, and advantages of the invention will be apparent from the description and drawings, and from the claims.

### DESCRIPTION OF DRAWINGS

FIGS. 1A-B are conceptual diagrams of example systems for identifying a finger or a type of finger and interpreting touch input using the identified finger or type of finger.
FIG. 2 is a diagram of an example system for identifying a finger or a type of finger and interpreting touch input using the identified finger or type of finger.
FIGS. 3A-C are flowcharts showing example techniques for identifying a finger or a type of finger and interpreting touch input using components of the example system described with regard to FIG. 2.
FIGS. 4A-E are diagrams of an example mobile computing device for determining a position of the mobile computing device with respect to a user.
FIGS. 5A-B are flowcharts showing example techniques for interpreting touchscreen input provided by a user.
FIGS. 6A-E are diagrams depicting examples of touch bias on a touchscreen.
FIG. 7, a conceptual diagram of a system that may be used to implement the systems and methods described in this document is illustrated.
FIG. 8 is a block diagram of computing devices that may be used to implement the systems and methods described in this document, as either a client or as a server or plurality of servers.

Like reference symbols in the various drawings indicate like elements.

### DETAILED DESCRIPTION

This document generally describes techniques, methods, devices, and systems for identifying a particular finger (e.g., right thumb, right index finger, left thumb, etc.) or a type of finger (e.g., thumb, finger, index finger, etc.) that has touched a touchscreen display of a mobile computing device (e.g., mobile phones, smart phones, PDAs, portable media players etc.). For instance, if a user presses a virtual button displayed on the touchscreen display of a mobile computing device using the user's right index finger, the mobile computing device can identify that the touch input from the button press was provided by the user's right index finger.

The techniques, methods, devices, and systems described in this document allow for touch input to be treated differently by a mobile computing device based on a particular finger or a type of finger that provided the input. For instance, instead of performing the same action(s) in response to touch input regardless of the finger or type of finger that provided the touch input, particular actions can be performed depending on the finger or type of finger identified as providing the touch input. For example, a mobile computing device can be configured to treat touches from a user's thumbs and index fingers as "left clicks" and all other touches (middle finger, ring finger, and pinky finger touches) as "right clicks" - permitting traditional left and right mouse click functionality to be simulated with touch input on a touchscreen.

In another example, touch bias can be corrected based on the finger or type of finger that touched the touchscreen. Touch bias can be a difference between an actual location at which a user touches a touchscreen display and a target location that the user intended to touch. Users may have difficulty accurately touching a targeted location on a touchscreen for a variety of reasons, such as the targeted location being obscured by the user's finger as the user is touching the touchscreen. The touch bias for touch input may be different depending on the finger or type of finger that is touches the touchscreen. For example, when the user touches a touchscreen with his/her right thumb, the user may habitually touch the screen 10 pixels to the right and 20 pixels down from an intended target location on the touchscreen. In contrast, when the user touches the touchscreen with his/her left index finger, the user may habitually touch the screen 5 pixels to the left and 5 pixels up from a target location on the touchscreen.

A correction applied to touch input can vary depending on the finger or type of finger identified as providing the touch input and a touch bias associated with the identified finger or type of finger. Continuing with the example from the previous paragraph, if a mobile computing device identifies that a user touched a touchscreen with his/her right thumb at a first location, the mobile computing device can correct for the touch bias associated with the user's right thumb (10 pixels to the right and 20 pixels down from an intended location) by registering the touch input being a second location that is 10 pixels to the left and 20 pixels up from the first location.

A finger or type of finger can be identified by a mobile computing device based on a combination of a plurality of factors, such as a manner in which a user is holding the mobile computing device, a contact area associated with a pointer (e.g., finger, type of finger) that touched the touchscreen, a level of pressure with which the pointer touched the touchscreen, etc. For example, if a user is holding a mobile computing device in his/her right hand, the user may be more likely to touch the touchscreen of the mobile computing device with his/her left index finger and/or right thumb. In another example, if a contact area from a pointer touching the touchscreen of a mobile computing device is relatively small (in comparison to an average contact area when the user touches the touchscreen), then it may be more likely that the user touched the touchscreen with his/her finger (or fingertip) than with his/her thumb. In a further example, if a level of pressure from a pointer touching the touchscreen of a mobile computing device is relatively high (in comparison with an average level of pressure associated with user touches), then it may be more likely that the user touched the touchscreen of the mobile computing device with his/her thumb or index finger than with his/her other fingers.

As explained in greater detail below, such factors can be used, alone or in combination, to identify a finger or type of finger that touched a touchscreen of a mobile computing device.

Models associated with fingers and types of fingers can additionally be used to identify a finger or a type of finger that touched a touchscreen. For example, a model associated with a user's right thumb may identify characteristics associated with the use of the right thumb to touch the touchscreen of a mobile computing device as including: the user holding the mobile computing device in his/her right hand or in both hands, a relatively large and egg-shaped contact area, the orientation of the contact area trending up the touchscreen from right to left (according to the orientation of a graphical user interface (GUI) on the touchscreen), a level of pressure being relatively high, etc. When the mobile computing device receives touch input that is associated with some or all of these characteristics, the mobile computing device (alone or in combination with a remote computing system) may identify that the touch input was received from the user's right thumb.

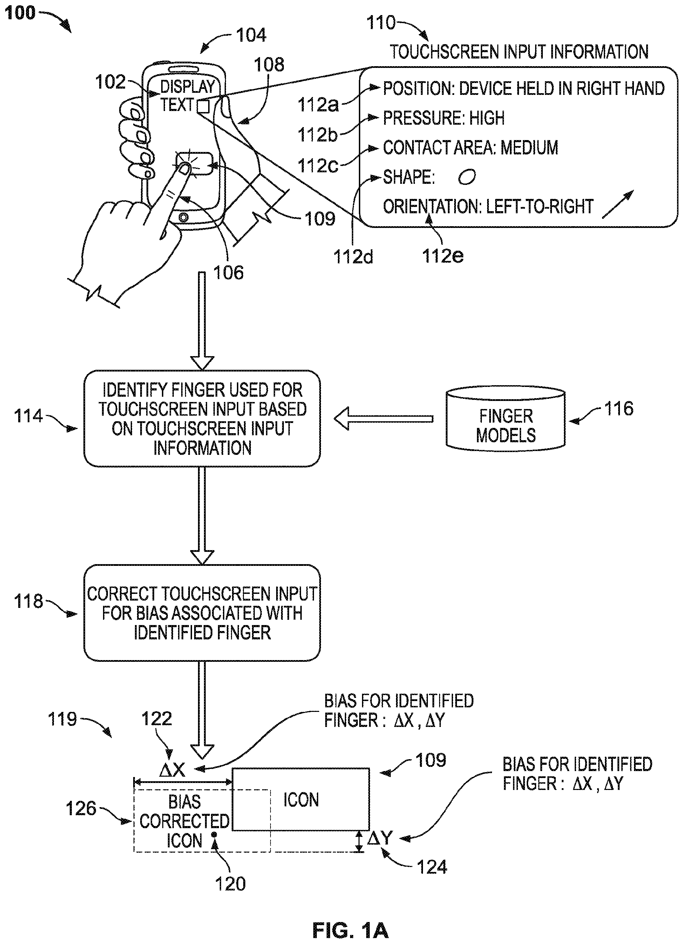

FIGS. 1A-B are conceptual diagrams of example systems 100 and 150 for identifying a finger or a type of finger and interpreting touch input using the identified finger or type of finger. The example system 100 is depicted as identifying a finger or type of finger used to touch a touchscreen display of a mobile computing device and correcting the touch input for touch bias associated with the identified finger or type of finger. The example system 150 is depicted as identifying a finger or type of finger used to touch a touchscreen of a mobile computing device and performing an action associated with the identified finger or type of finger.

Referring to FIG. 1A, a user is depicted as touching a touchscreen display 102 of a mobile computing device 104 with his/her left index finger 106. The user is depicted as holding the mobile computing device 104 in his/her right hand 108 and as attempting to touch an icon 109 that is displayed on the touchscreen 102.

The mobile computing device 104 can be any appropriate type of mobile computing device, such as a mobile telephone, a smart phone, a PDA, a portable media player (e.g., a portable video game player, a portable music player, a portable electronic reader), etc. The touchscreen 102 can be any of a variety of appropriate styles of touchscreen capable of receiving touch input, such as a capacitive touchscreen, a resistive touchscreen, an infrared touchscreen, etc.

Information 110 associated with the touch input can be used to identify the finger (right index finger) or the type of finger (finger, index finger, finger on right hand, etc.) that touched the touchscreen 102. For example, the information 110 can include: a position of the mobile computing device 104 with respect to the user (112a), a level of pressure associated with the touch input (112b), an area of contact associated with the touch input (112c), a shape of the touch input on the touchscreen 102 (112d), and an orientation of the touch input on the touchscreen 102 (112e). Other information associated with the touch input and/or the mobile computing device 104 not included in the example information 110 can be used to identify the finger or type of finger that touched the touchscreen 102 (e.g., visual information (e.g., image from camera of the finger touching the touchscreen 102), gesture information (e.g., an action or motion made by the user with respect to the mobile computing device 104), etc.).

The information 112a regarding the position of the mobile computing device 104 can indicate a variety of information regarding the physical proximity of the mobile computing device 104 to the user. For example, the information 112a can indicate how the user is holding the mobile computing device 104. For instance, the user may hold the mobile computing device 104 with his/her right hand, left hand, with both hands, with no hands, with an index finger and thumb, in the palm of the user's hand with all fingers and the user's thumb (as depicted in the example system 100), etc. In another example, the information 112a can indicate an angle of the mobile computing device 104 and/or the touchscreen 102 with regard to the user. For instance, a user may hold the mobile computing device 104 so that the touchscreen 102 is facing and parallel to the user, so that the touchscreen 102 is perpendicular to the user, or any other of a variety of relevant angles with respect to the user.

In the example depicted for the system 100, the information 112a indicates that the user is holding the mobile computing device 104 is his/her right hand.

The information 112b regarding a level of pressure associated with the touch input can indicate an amount of force that is exerted on the touchscreen 102 by the user when the user is providing the touch input. For example, the level of pressure can range from a low level, which may be generated by a light press or tap of the touchscreen 102, to a high level, which may be produced by the user firmly squeezing the mobile computing device 104 between his/her thumb and index finger. As depicted in the example 100, the information 112b indicates that the touch input was received with a "high" level of pressure.

The information 112c regarding the contact area associated with the touch input can indicate an area of the touchscreen 102 that was contacted by the user's finger 106. For example, the contact area when the user touches the touchscreen 102 with his/her index finger is likely to be smaller than the contact area associated with the user touching the touchscreen 102 with his/her thumb. In the example 100, the information 112c indicates a "medium" contact area associated with the finger 106 touching the touchscreen 102.

The information 112d regarding the shape of the touch input indicates a shape of the area of the touchscreen 102 touched by the finger 106. For instance, the when the user touches the touchscreen 102 with his/her thumb, the resulting shape may be wider than a shape produced when the user touches the touchscreen 102 with his/her index finger. The information 112d can include a variety of information regarding the shape of the contact area, such as the length and width of the contact area, data points outlining the perimeter of the contact area, etc. As depicted in the example system 100, the information 112d indicates an outline of the contact area.

The information 112e regarding the orientation of the touch input indicates an orientation of the touch input with respect to information displayed on the touchscreen 102. For example, with information being displayed on the mobile computing device 104 consistent with the "Display Text" on the touchscreen 102, the orientation of the finger 106 is from left-to-right from the base to the tip of the contact area.

As depicted at step 114, the finger or type of finger used to touch the touchscreen 102 is identified using some or all of the information 112a-e. Various inferences regarding the finger or type of finger that touched the touchscreen 102 can be drawn from the information 112a-e. For example, the information 112a (specifying that the user is holding the mobile computing device 104) can indicate that the user likely used his/her right thumb or left fingers to touch the touchscreen 102. The information 112b (specifying a high level of pressure) can indicate that the user likely touched the touchscreen 102 with his/her index finger or thumb. The information 112c (specifying a medium contact area) can indicate that the finger that touched the touchscreen 102 is likely to be the user's index finger, middle finger, or ring finger, as opposed to the user's thumb (large contact area) or pinky finger (small contact area). The information 112d (specifying the shape of the contact area) can indicate that the user likely touched the touchscreen 102 with his/her fingers instead of his/her thumb. The information 112e (specifying the orientation of the touch input) can indicate that the user likely touched the touchscreen 102 with his/her left hand.

When combined, the inference drawn from some or all of the information 112a-e can indicate that the user touched the touchscreen 102 with his/her left index finger. For example, the left index finger can be identified as the pointer that touched the touchscreen 102 based on the position information 112a, pressure information 112b, and orientation information 112e. From the position information 112a, the pointer can be narrowed down to one of the user's right thumb or one of the user's left fingers. The pointer can further be narrowed down to the user's right thumb or left index finger from the pressure information 112b, and can be identified as the left index finger from the orientation information 112e. The information 112a-e, as well as other information not included in this example system 100, can be used alone or in various combinations to identify the finger or type of finger that touched the touchscreen 102.

Finger models 116 can additionally be used to identify a finger or type of finger that touched the touchscreen 102 as part of step 114. A model for a finger or a type of finger defines various values of the information 112a-e that are associated with touch input from the finger or type of finger. For example, a model for the user's left index finger may specify the following values for the information 112a-e: for the position information 112a, that the mobile computing device 110 is held in the user's right hand; for the pressure information 112b, a medium or high level of pressure; for the contact area information 112c, a medium contact area; for the shape information 112d, an oblong shape; and for the orientation information 112e, a left-to-right orientation. The finger models 116 can be compared to the touchscreen information 112a-e to identify a finger or a type of finger that provided the touchscreen input.

The finger models 116 can be user specific, in that the finger models for a first user can be different than the finger models for a second user. The finger models 116 can be learned and continually updated based on touch input and finger identifications for a user. For example, if a user touches the touchscreen 102 and the finger or type of finger is incorrectly identified, then the model(s) associated with the incorrectly identified finger or type of finger can be adjusted based on information associated with the touch input. Incorrect identification can be detected based on actions taken by the user subsequent to finger or type of finger identification. For instance, incorrect identification can be indicated by a user undoing or modifying an action performed in association with the identified finger or type of finger. For example, if the mobile computing device 104 displays a menu in response to touch input identified as being received from a user's pinky finger and, in response to displaying the menu, the user immediately returns to from the menu to a previous screen to provide similar touch input, then the identification of the pinky finger may be labeled as an incorrect and a model associated with the pinky finger can be adjusted accordingly.

The step 114 can be performed by the mobile computing device 104 alone or in combination with a computing system (not depicted) that is remote from the mobile computing device 104. For example, the mobile computing device 104 can provide some or all of the information 112a-e (or data used to determine the information 112a-e) to the remote computing system over a network (e.g., wireless network, cellular network, 3G network, 4G network, etc.) to perform the finger or finger type identification. Similarly, some or all of the finger models 116 may be maintained by the remote computing system. Remote maintenance of the finger models 116 for a particular user can permit for the finger models 116 learned for the particular user on the mobile computing device 104 to be used on other computing devices. For example, the finger models 116 could be shared across a smart phone and a laptop computer that receive input through touchscreen displays, and such coordination may occur via an on-line account for a user of the two devices when the user logs in on each respective device.

In the example system 100, the touchscreen input is corrected for touch bias associated with the identified finger (step 118). As described above, touch bias is a difference between a location at which the user actually touches the touchscreen 102 and a target location the user was attempting to touch. Touch bias can vary depending on a finger or types of finger that provided the touch input. For example, the touch bias the user's right thumb may be a different amount and/or direction than the touch bias for the user's left index finger.

As depicted in the example graphic 119, the user is attempting to touch the icon 109 - the target location on the touchscreen 102. Instead of touching the icon 109, the user touches a location 120 (the actual touch location) that is to the left of the icon 109. A touch bias associated with the user's identified finger (left index finger) in this example is indicated by ΔX 122 and ΔY 124 - meaning that touch input received from the user's left index finger are generally offset from an intended target on the touchscreen 102 by ΔX 122 and ΔY 124. Accordingly, the coordinates for the actual touch location 120 (or the icon 109) can be corrected by ΔX 122 and ΔY 124 so as to make the actual touch location 120 coincide with the intended target on the touchscreen 102. The bias corrected icon 126 depicts how adjustment of the touch input (or graphical elements displayed on the touchscreen 102) according to the touch bias ΔX 122 and ΔY 124 for the identified finger can adjust the actual location 120 of the touch input to be the intended touch target (the icon 109).

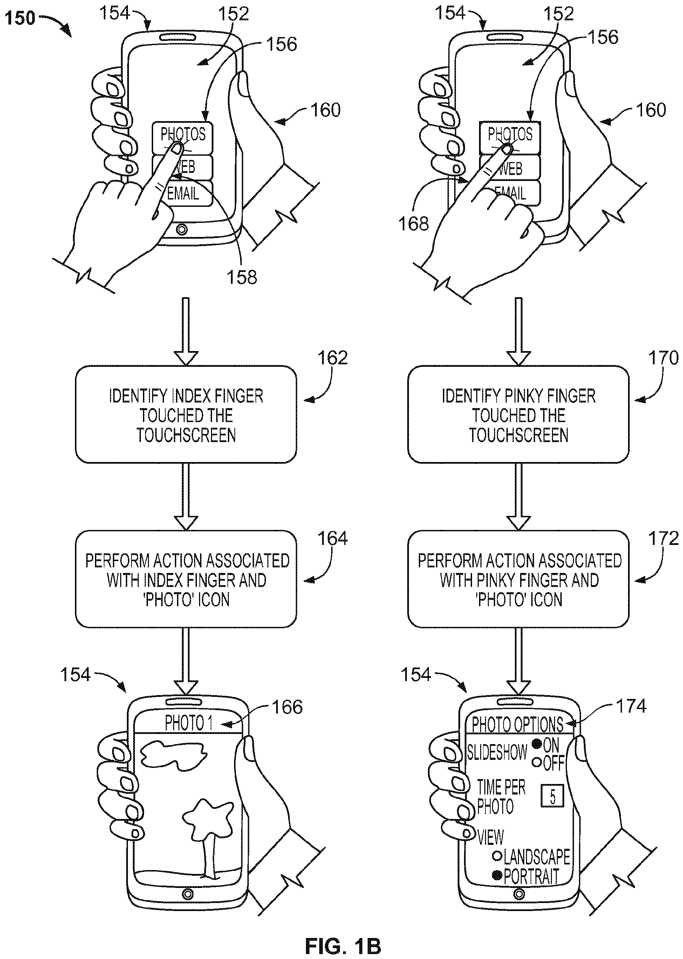

Referring to FIG. 1B, the example system 150 demonstrates the performance of distinct actions based on the finger or type of finger that is identified as providing touch input. In the example system 150, a user is depicted as touching a touchscreen 152 of a mobile computing device 154 on a displayed "Photos" icon 156 using his/her left index finger. The user is depicted as holding the mobile computing device in his/her right hand 160.

Using information and techniques for identifying a finger discussed above with regard to FIG. 1A, the touch input is identified as being provided by the user's index finger (step 162).

In step 164, an action associated with the user's index finger and the "Photos" icon 156 is performed. Graphical elements (e.g., icons, buttons, keys, text fields, images, links, menus, videos, desktop background, etc.) can each be associated with various actions, like the actions traditionally associated with right and left mouse clicks (e.g., left clicking on an icon can cause a program to load a document associated with the icon and right clicking on the icon can present a menu of options related to the document, such as copy, delete, rename, etc.). These actions can additionally be associated with fingers or types of fingers such that a particular action can be performed based on the finger or type of finger identified as providing touch input related to a graphical element. For example, touching the icon 156 with an index finger can cause a first action associated with the icon 156 to be performed, touching the icon 156 with a thumb can cause a second action to be performed, and touching the icon 156 with a pinky finger can cause a third action to be performed on the mobile computing device 154.

In the example depicted, the action associated with touch input from an index finger and the icon 156 causes the mobile computing device 154 to display a photo 166.

In contrast, when the user touches the icon 156 displayed on the touchscreen 152 of the mobile computing device 154 with his/her pinky finger 168, a different action is performed. In response to receiving the touch input, the user's pinky finger is identified at step 170 as having touched the touchscreen 152. At step 172, an action associated with the pinky finger and the icon 156 is performed. In this example, the action associated with touch input from a pinky finger and the icon 156 causes the mobile computing device 154 to display a set of photo options 174 related to displaying photos on the mobile computing device 154.

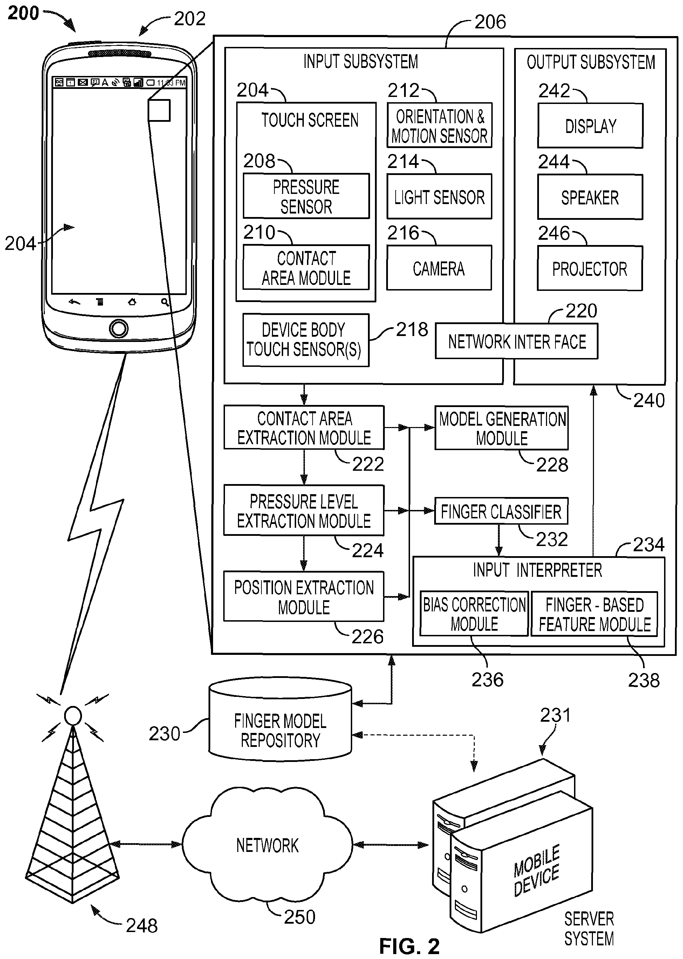

FIG. 2 is a diagram of an example system 200 for identifying a finger or a type of finger and interpreting touch input using the identified finger or type of finger. The system 200 is similar to the systems 100 and 150 described above with regard to FIGS. 1A-B. The system includes a mobile computing device 202 with a touchscreen 204, similar to the mobile computing devices 104 and 154 described with regard to FIGS. 1A-B. The mobile computing device 202 receives touch input from a user by the user touching the touchscreen 204 with a pointer (e.g., finger, thumb, etc.). Based on this touch input, the mobile computing device 202 is able to identify a finger or type of finger that touched the touchscreen 204 and interpret the touch input according to the identified finger or type of finger.

The touchscreen 204 (e.g., a capacitive touchscreen, resistive touchscreen, an infrared touchscreen, etc.) is part of an input subsystem 206 of the mobile computing device 202 that is configured to receive input for the mobile computing device 202. The touchscreen 204 is depicted as including a pressure sensor 208 and a contact area module 210. The pressure sensor 208 can be any of a variety of appropriate pressure sensors that can be integrated into or combined with a touchscreen display, such as pressure sensors installed below the surface of the touchscreen 204 that are configured to receive pressure readings based on an amount of force exerted on the touchscreen 204. The pressure sensor 208 can provide measurements regarding an amount of force applied to the touchscreen 204, which can indicate a level of pressure associated with a user touching the touchscreen 204. The contact area module 210 measures an area of the touchscreen 204 touched by a user and provides data indicates the contact area and/or shape associated with the touch input.

In addition to the touchscreen 204, the depicted input subsystem 206 includes orientation and motion sensors 212, a light sensor 214, a camera 216, device body touch sensor(s) 218, and a network interface 220. The orientation and motion sensors 212 can provide measurements regarding an orientation (e.g., facing north, positioned upright (perpendicular to the ground), etc.) and/or movement (e.g., stationary, accelerating forward, travelling at a high rate of speed, etc.) of the mobile computing device 202. The orientation and motion sensors 212 can be any of a variety of sensors that are capable of providing such measurements, such as gyroscopes, accelerometers, compasses, global positioning system (GPS) units, etc.

The light sensor 214 can be positioned on the exterior of the mobile computing device 202 and measure an amount of ambient light. The measurements provided by the light sensor 214 can indicate whether a portion of the mobile computing device 202 is covered by a portion of the user's hand (e.g., the manner in which the user is holding the mobile computing device 202 is causing the light sensor 214 to be covered). The camera 216 may be used to capture images and/or video of a user holding and/or touching the touchscreen 204. The captured images and/or video may be analyzed to determine a position of the mobile computing device 202 relative to the user and/or to identify a finger or type of finger that touched the touchscreen 204.

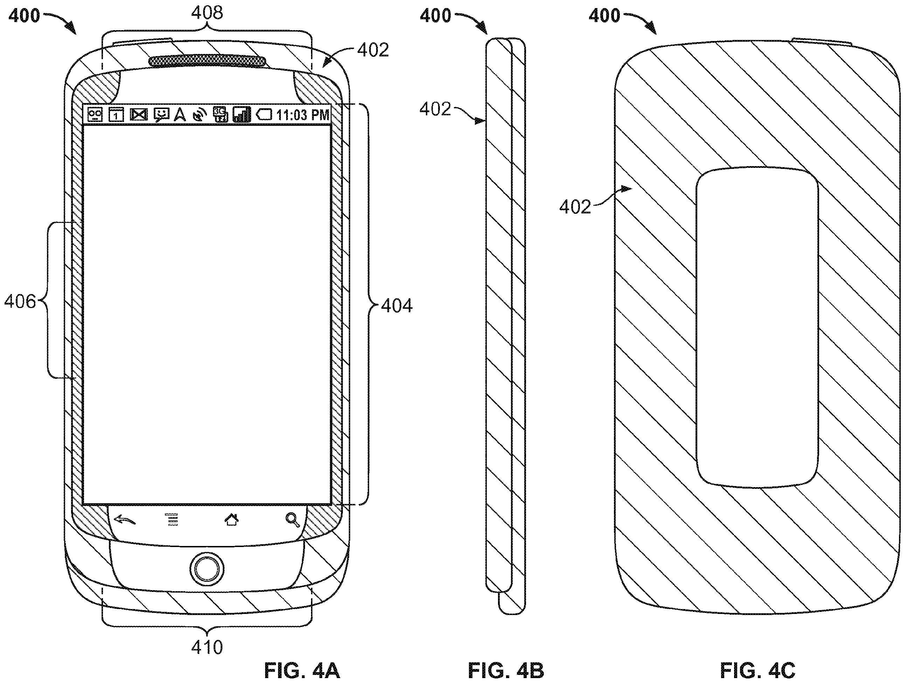

The device body touch sensors 218 are touch sensors that can be configured around the body of the mobile computing device 202 to capture touch input related to a manner in which the user is holding the mobile computing device 202. Examples the device body touch sensors 218 are provided in FIGS. 4A-C.

The network interface 220 interacts with computing systems that are external to the mobile computing device 202 to send and receive electronic information. The network interface 220 can be any of a variety of appropriate networking interfaces (e.g., Ethernet card, wireless network card, cellular transmitter, etc.) that are capable of sending and receiving information over a network (e.g., local area network (LAN), the Internet, wireless network, peer-to-peer network, cellular network, 3G network, etc.).

Input received through the input subsystem 206 of the mobile computing device 202 can be provided to the contact area extraction module 222, the pressure level extraction module 224, and the position extraction module 226. The contract area extraction module 222 can use input received from the input subsystem 206 to determine the contact area, shape, and/or orientation associated with a user touching the touchscreen 204. For example, the contact area extraction module 222 can use information provided by the touchscreen 204 and the contact area module 210 to determine a contact area, shape, and/or orientation associated with touch input.

The pressure level extraction module 224 determines a level of pressure associated with a user touching the touchscreen 204 of the mobile computing device 202 from information provided by the input subsystem 206, such as measurements received from the pressure sensor 208.

The position extraction module 226 determines a position of the mobile computing device 202 relative to the user that provided touch input based on information provided by the input subsystem 206, such as measurements received from the orientation and motion sensors 212, the light sensor 214, the camera 216, and/or the device body touch sensors 218. For example, the position extraction module 226 can use input received through the device body touch sensors 218 to determine how the user is holding the mobile computing device 202. In another example, input received through the orientation and motion sensors 212 can be used by the position extraction module 226 to determine an orientation of the mobile computing device 202 with respect to the surrounding environment. In a further example, input from the camera 216 can be used by the position extraction module 226 to visually locate the user with respect to the mobile computing device 202.

A model generation module 228 uses the information determined by the contact area extraction module 222, the pressure level extraction module 224, and/or the position extraction module 226 to generate models for particular fingers or types of fingers. As described above with regard to FIG. 1A, finger models can define input values for a finger or type of finger and can be used to identify the finger or type of finger that touched the touchscreen 204. The model generation module 228 can generate and update models during training modes for the mobile computing device 202 and during normal operation of the mobile computing device 202. A training mode can be a mode of operation during which a user is asked to identify touch input received as being a particular finger or type of finger. Models are stored in a finger model repository 230, which can store finger models local and/or remote from the mobile computing device 202. Finger models can be stored remote from the mobile computing device 202 with the assistance of a remote computing system, such as the mobile device server system 231.

A finger classifier 232 can also use the information determined by the contact area extraction module 222, the pressure level extraction module 224, and/or the position extraction module 226 to identify a finger or type of finger that touched the touchscreen 204. The finger classifier 232 can use the information from the modules 222-226 to infer a finger or type of finger that provided the touch input, similar to the description of finger identification provided above with regard to FIG. 1A. The finger classifier 232 can identify the finger or type of finger that provided touch input using finger models from the finger model repository 232.

An input interpreter 234 uses the identification of a finger or type of finger by the finger classifier 232 to interpret touch input received by the touchscreen 204. The input interpreted 234 includes a bias correction module 236 and a finger-based feature module 238. The bias correction module 236 corrects touch input for a touch bias associated with the identified finger or type of finger, similar to the bias correction described above with regard to FIG. 1A. The finger-based feature module 238 performs various actions associated with a graphical element touched by the user and the identified finger or type of finger, similar to the actions described above with regard to FIG. 1B. The input interpreter 234 can interpret touch input using the bias correction module 236 and/or the finger-based feature module 238.

An output subsystem 240 provides output to a user of the mobile computing device 202 based on interpretation of the received touch input by the input interpreter 234. For example, the output subsystem 240 can cause the touchscreen 204 to display the photo 166 or the photo options 174 based on an action associated with the identified finger or type of finger, as described with regard to FIG. 1B. The output subsystem 240 can include a variety of devices for providing output to a user of the mobile computing device 202, such as a display 242 (which may be included as part of the touchscreen 204), a speaker 244, and a projector 246.

The mobile computing device 202 can wirelessly communicate with wireless transmitter 248 (e.g., a cellular network transceiver, a wireless network router, etc.) and obtain access to a network 250 (e.g., the Internet, public switched telephone network (PSTN), a cellular network, a local area network (LAN), a virtual private network (VPN), etc.). Through the network 250, the mobile computing device 202 can be in communication with a mobile device server system 231 (one or more networked server computers), which can be configured to provide mobile device related services and data to the mobile device 202 (e.g., provide calendar data, email data, connect telephone calls to other telephones, etc.). Through the wireless transmitter 248 and the network 250, the mobile device server system 231 can implement some of the features described above with regard to the mobile computing device 202, such as identifying a finger or type of finger using finger models stored in the finger model repository 230.

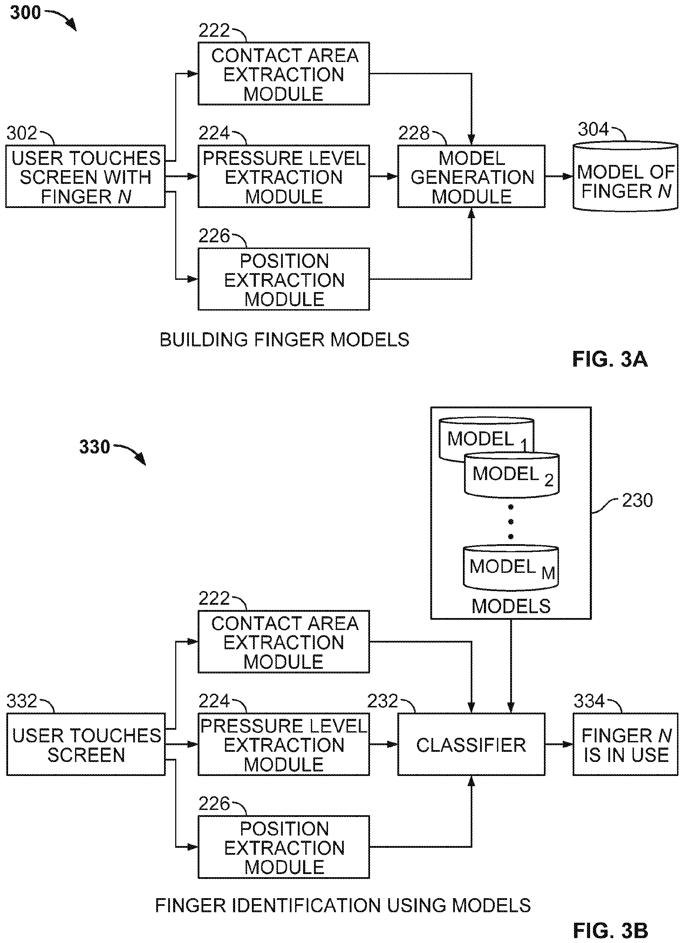

FIGS. 3A-C are flowcharts showing example techniques 300, 330, and 360 for identifying a finger or a type of finger and/or interpreting touch input using components of the example system 200 described with regard to FIG. 2. The example technique 300 depicts building finger models based on touch input from a user. The example technique 330 depicts identifying a finger or type of finger that provided touch input using finger models, which can be generated using the technique 300. The example technique 360 depicts correcting touch input for touch bias associated with a finger or type of finger, which may be identified using the technique 330.

Referring to FIG. 3A, the technique 300 begins with a user touching a touchscreen (e.g., the touchscreen 204) with a finger n (step 302). Input associated with the user touching the touchscreen is provided to one or more of the contact area extraction module 222, the pressure level extraction module 224, and the position extraction module 226, which determine a contact area associated with the touch input, a level of pressure associated with the touch input, and a position of the mobile computing device (e.g., the mobile computing device 202) with regard to the user, respectively. The model generation module 228 uses the information determined by one or more of the modules 222-226 to generate a model 304 for the finger n. The model 304 for finger n can be stored in a finger model repository (e.g., the finger model repository 230) for use identifying a finger based on touch input, such as the identification performed with technique 330.

Referring to FIG. 3B, the technique 330 begins with a user touching a touchscreen with a finger (step 332). Input associated with the user touching the touchscreen is provided to one or more of the contact area extraction module 222, the pressure level extraction module 224, and the position extraction module 226, which determine a contact area associated with the touch input, a level of pressure associated with the touch input, and a position of the mobile computing device with regard to the user, respectively. The finger classifier 232 can use the information determined by the modules 222-226 and the finger models stored in the finger model repository 230 (including the finger model 304 generated for finger n in technique 300) to identify that the user has touched the touchscreen with finger n (step 334).

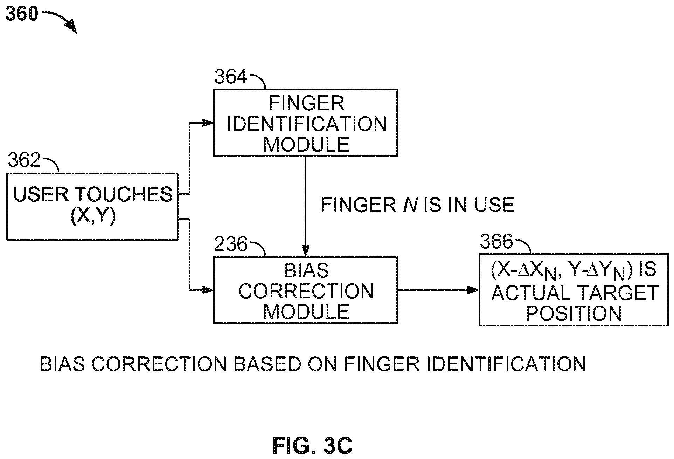

Referring to FIG. 3C, the technique 360 begins with a user touching a touchscreen at position (x, y) on the touchscreen (step 362). A finger identification module 364, which may use the technique 330, identifies that the touchscreen was touched by finger n. Using the identified finger n for the touch input, the bias correction module 236 corrects the position (x, y) for the touch input based on a touch bias associated with the finger n. In this example, the touch bias associated with the finger n is (Δxₙ, Δyₙ), where Δxₙ is the x offset on the touchscreen for the finger n and Δyₙ is the y offset on the touchscreen for finger n. Based on the bias correction for finger n, an actual target position (x-Δxₙ, y-Δyₙ) is determined for the touch input at position (x, y) (step 366).

FIGS. 4A-E are diagrams of example mobile computing devices for determining a position of the mobile computing device with respect to a user. FIGS. 4A-C depict a mobile computing device 400 that includes touch sensors 402 embedded on the body of the mobile computing device, such as the device body touch sensors 218 described above with regard to FIG. 2. The touch sensors 402 can be any of a variety of appropriate touch sensors, such as capacitive touch sensors. The mobile computing device 400 is similar to the mobile computing devices 104, 154, and 202 described above with regard to FIGS. 1A, 1B, and 2, respectively.

FIG. 4A provides a front view of the mobile computing device 400 with the touch sensors 402 included around the perimeter of the device 400. The example pattern of the touch sensors 402 on the device 400 allows for determination of the portions of the mobile computing device 400 that a user is holding, which can indicate a position of the mobile computing device 400 with respect to the user. For instance, if the touch sensors 402 provide that portions 404 and 406, located on the right and left side of the mobile computing device 400, respectively, are being touched by the user, it likely indicates that the user is holding the device with his/her right hand - the user's palm and right thumb may be touching the portion 404 and one or more of the user's right fingers may be touching the portion 406. In another example, if the touch sensors provide that portions 408 and 410, located on the top and bottom of the mobile computing device 400, respectively, are being touched by the user, it likely indicates that the user is holding the device 400 sideways with both hands - one of the user's hands is touching the portion 408 and the other hand is touching the portion 410.

FIG. 4B depicts a perspective view of the mobile computing device 400 and the touch sensors 402. The touch sensors 402 can span some or all of the side of the mobile computing device 400. FIG. 4B depicts the example touch sensors 402 as extending down the entire side of the mobile computing device 400. Other patterns and/or placement of touch sensors 402 can be used.

FIG. 4C depicts a view of the back of the mobile computing device 400. In this example, the touch sensors 402 are positioned around the perimeter of the mobile computing device 400. Any of a variety of appropriate touch screen patterns and/or designs can be used.

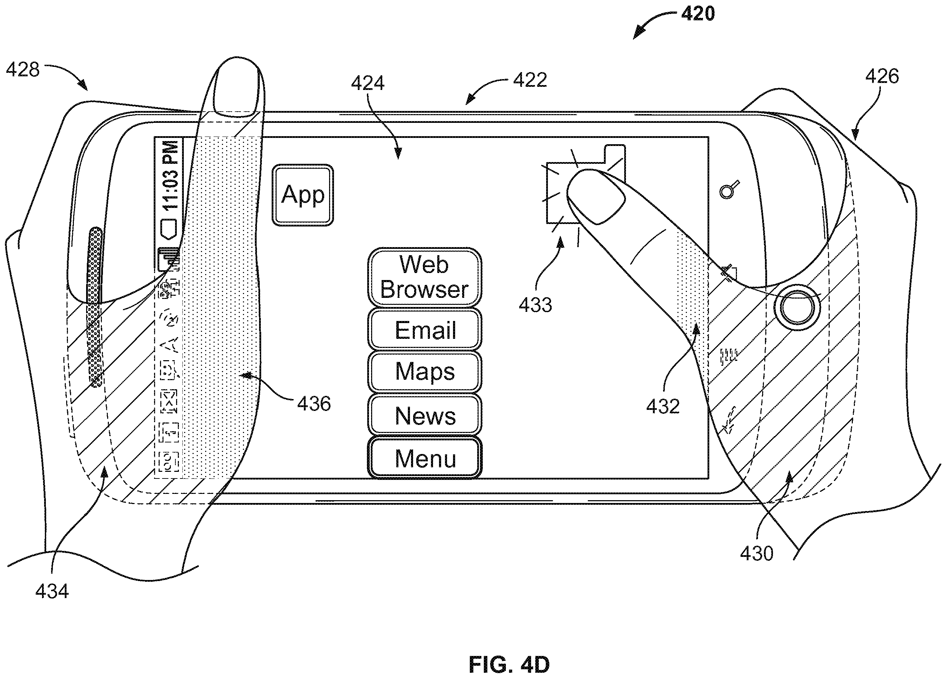

FIGS. 4D-E depict example diagrams 420 and 440 of touch input provided by a user holding a mobile computing device with touch sensors included in the body of the device. The touch input provided in the example diagrams 420 and 440 can be used to determine a position of the mobile computing device with respect to the user.

Referring to FIG. 4D, the example diagram 420 depicts a mobile computing device 422 with a touchscreen 424 that is displaying a menu and two icons. A user is shown as holding the device 422 sideways with both his/her right hand 426 and left hand 428. Portions 430 of a touch sensor included in the body of the device 422 (e.g., touch sensor 402) may indicate the user is touching the device's right side (when the device is held sideways). Additionally, portion 432 of the touchscreen 424 may indicate that some of the user's right thumb is touching the touchscreen 424 away from an intended point of contact 433. Portions 434 of the touch sensor include in the body of the device 422 and portions 436 of the touchscreen 424 can indicate that the user is touching the device's left side. Based on the portions 430, 432, 434, and 436 that are being touched by the user, the position of the mobile computing device 422 can be determined to being held by the user with both hands.

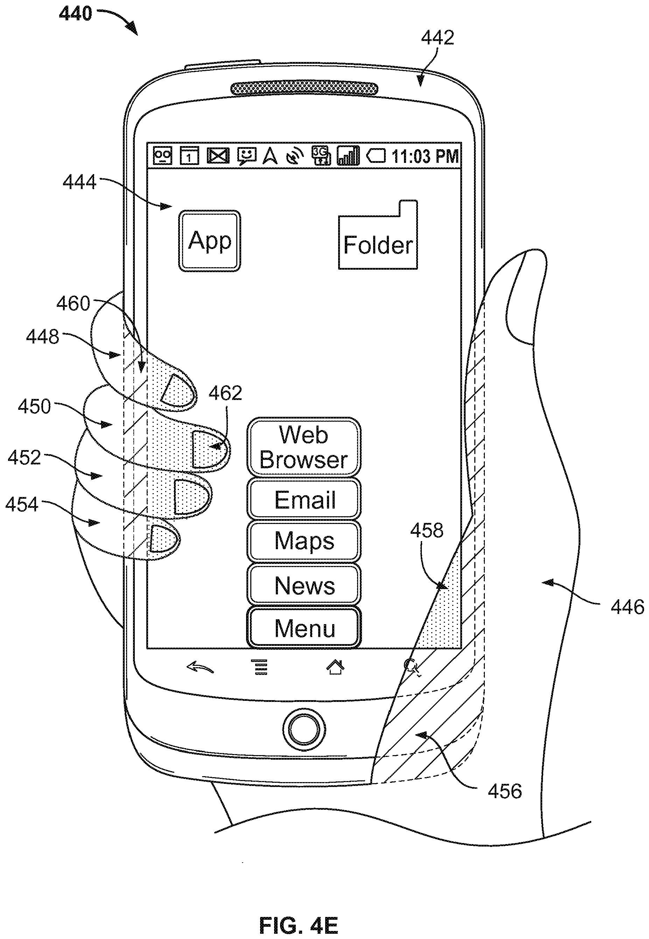

Referring to FIG. 4E, the example diagram 440 depicts a mobile computing device 442 that includes a touchscreen 444 displaying the same menu and icons as the touchscreen 424. A user is shown as holding the device 442 with the his/her right thumb 446 and right fingers 448-454. A touch sensor included in the body of the device 442 can indicate that portions 456 and 460 of the device are being touched by the user. Additionally, the touchscreen 444 can indicate that portions 458 and 462 of the touchscreen are being touched by the user. Based on the portions 456-462 that are indicated as being touched by the user, the position of the mobile computing device 442 with respect to the user can be determined as the user holding the mobile computing device 442 in his/her right hand.

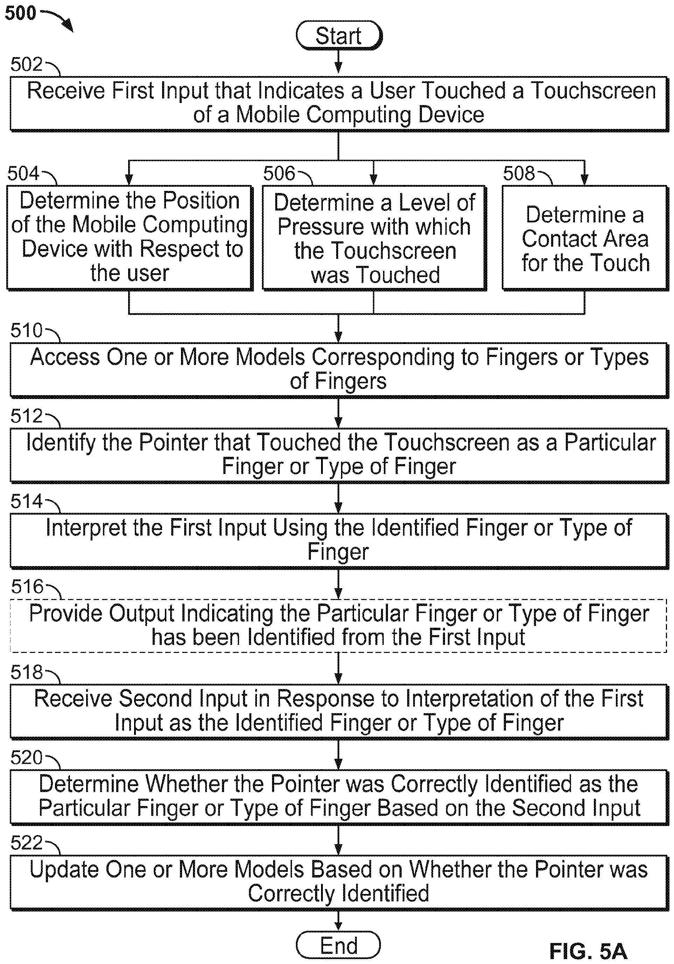

FIGS. 5A-B are flowcharts showing example techniques 500 and 550 for interpreting touchscreen input provided by a user. The example technique 500 is directed to identifying a finger or a type of finger and interpreting touch input using the identified finger or type of finger. The example technique 550 is directed to interpreting touch input corresponding to a graphical element according to a touch bias associated with the graphical element. The example techniques 500 and 550 can be performed using any of a variety of appropriate computing systems and/or mobile computing devices, such as the mobile computing devices 104, 154, 202, 400, 422, and 444 described above with regard to FIGS. 1A, 1B, 2, 4A-C, 4D, and 4E, respectively.

Referring to FIG. 5A, the technique 500 starts at step 502 by receiving first input that indicates a user touched a touchscreen of a mobile computing device. For example, the user touches the touchscreen 102 of the mobile computing device 104 with his/her left index finger 106, as described above with regard to FIG. 1A. The position of the mobile computing device with respect to the user can be determined (step 504), a level of pressure with which the touchscreen was touched can be determined (step 506), and/or a contact area for the touch can be determined (step 508). For instance, steps 504-506 can be performed by the position extraction module 226, the pressure level extraction module 224, and the contact area extraction module 222, respectively, as described above with regard to FIG. 2.

One or more models corresponding to fingers or types of finger are accessed (step 510). For example, finger models can be retrieved from the finger model repository 230, as described above with regard to FIG. 2. The pointer that touched the touchscreen is identified as a particular finger or type of finger (step 512). For instance, the finger that touched the touchscreen 102 of the mobile computing device 104 is identified in step 114, as described above with regard to FIG. 1A. The first input is interpreted using the identified finger or type of finger (step 514). For example, the touchscreen input is interpreted by correcting for a touch bias associated with the identified finger in step 118, as described with regard to FIG. 1A. In another example, the touchscreen input is interpreted by performing an action associated with the identified finger in steps 164 and 172, as described above with regard to FIG. 1B.

In some implementations, output can be provided indicated that the particular finger or type of finger has been identified based on the first touch input (step 516). For example, if a mobile computing device is in a training mode, the mobile computing device may display information indentifying the particular finger or type of finger identified from the first input. In addition, the mobile computing device may display information that asks the user for input regarding whether the finger or type of finger was correctly identified. A model associated with the identified finger or type of finger can be adjusted based on the user's response to such an identification query.

Second input is received in response to interpretation of the first input as the identified finger or type of finger (step 518). The second input can be touch input or some other type of input (e.g., the user shaking the device, the user pressing a button or key on the mobile computing device, the user providing audio input, etc.). A determination of whether the pointer was correctly identified as the particular finger or type of finger can be made based on the second input (step 520). One or more models are updated based on whether the pointer is determined to have been correctly identified as the particular finger or type of finger (step 522).

For example, assume that a user touches the touchscreen 152 of the mobile computing device 154 with his/her index finger 158 and that the touch input is incorrectly identified as the user's pinky finger 168. In response to the identification, the mobile computing device 154 incorrectly performs the action associated with the pinky finger 168 and presents the photo options 174 to the user. In response to receiving the wrong screen, the user may provide second input that causes the device to go back to the menu 156 so that the user can provide input that will cause the device 154 to present the photo 166. The second input can be any variety of input that is relevant to the example here, such as the user touching a menu button displayed on the touchscreen, shaking the device to "undo" the previous action, pressing a button or key on the body of the device 154, etc. The second input can be identified as indicating that the user did not want to view the photo options 174 and, accordingly, that the pointer was incorrectly identified as being the user's pinky finger. A finger model associated with the pinky finger 168 and/or the index finger 158 can be updated according to the incorrect identification.

In alternate example, assume that the user is presented with the photo options 174 in response to touching the touchscreen 152 with his/her pinky finger 168 and that the user proceeds to interact with the photo options 174 (e.g., change the slideshow from ON to OFF). In this example, the user's action can indicate that the user wanted to view the photo options 174 and, accordingly, that the pinky finger was correctly identified from the first input. A finger model for the pinky finger can be updated to indicate the correct identification based on the first input.

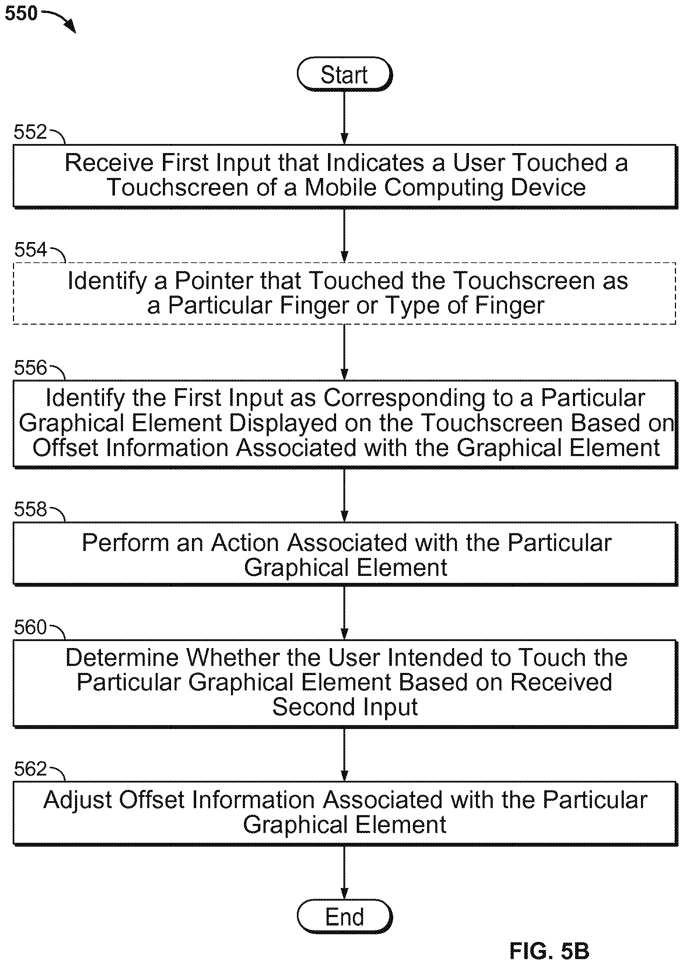

Referring to FIG. 5B, the technique 550 starts at step 552 by receiving first input that indicates a user touched a touchscreen of a mobile computing device. For example, the user touches the touchscreen 102 of the mobile computing device 104 with his/her left index finger 106, as described above with regard to FIG. 1A. In some implementations, the pointer that touched the touchscreen is identified as a particular finger or type of finger (step 554). For instance, the finger that touched the touchscreen 102 of the mobile computing device 104 is identified in step 114, as described above with regard to FIG. 1A.

The first input can be identified as corresponding to a particular graphical element displayed on the touchscreen based on offset information associated with the graphical element (step 556). Graphical elements (e.g., keys, buttons, text fields, images, etc.) can have an associated touch bias that is used to correctly associate touch input with the graphical element. For example, first and second graphical elements displayed on a touchscreen can have a touch biases indicating that user touches associated with the first graphical element are biased to the left and that user touches of the second graphical element are biased to the right. When receiving touch input, an active area for a graphical element (an area within which touch input is received for the graphical element) can be shifted to correct for the touch bias associated with the graphical element (e.g., shifting an active area for the icon 109 to the bias corrected icon 126). The touch input can be identified as corresponding to a graphical element using the bias corrected active areas for the graphical elements displayed on the touchscreen.

The touch bias associated with graphical elements may be specific to the identified finger or type of finger. For example, the touch bias associated with a graphical element may change depending on the finger or type of finger that is touching the graphical element. In another example, the touch bias for a finger or type of finger may be different for graphical elements located at various positions on a touchscreen.

The touch bias may also be aggregated for some or all fingers/types of fingers. For instance, instead of having a touch bias associated with various finger/types of fingers, a graphical element may have a single touch bias that is used for processing input for all fingers/types of fingers.

An action associated with the particular graphical element identified as corresponding to the first input can be performed (step 558). For instance, based on the touch input 120 being located within the bias corrected icon 126 (the bias corrected active area for the icon 109), an action associated with the icon 109 can be performed, as described above with regard to FIG. 1A.

A determination as to whether the user intended to touch the particular graphical element can be made based on received second input (step 560). Similar to the steps 518-520 described above with regard to FIG. 5A, received second input can indicate whether the user intended for the first input to correspond to the particular graphical element. Offset information associated with the particular graphical element can be adjusted based on the determination (step 562). Like step 522 described above with regard to FIG. 5A, touch bias information associated with the particular graphical element can be adjusted based on whether the first input was correctly or incorrectly identified as corresponding to the particular graphical element.

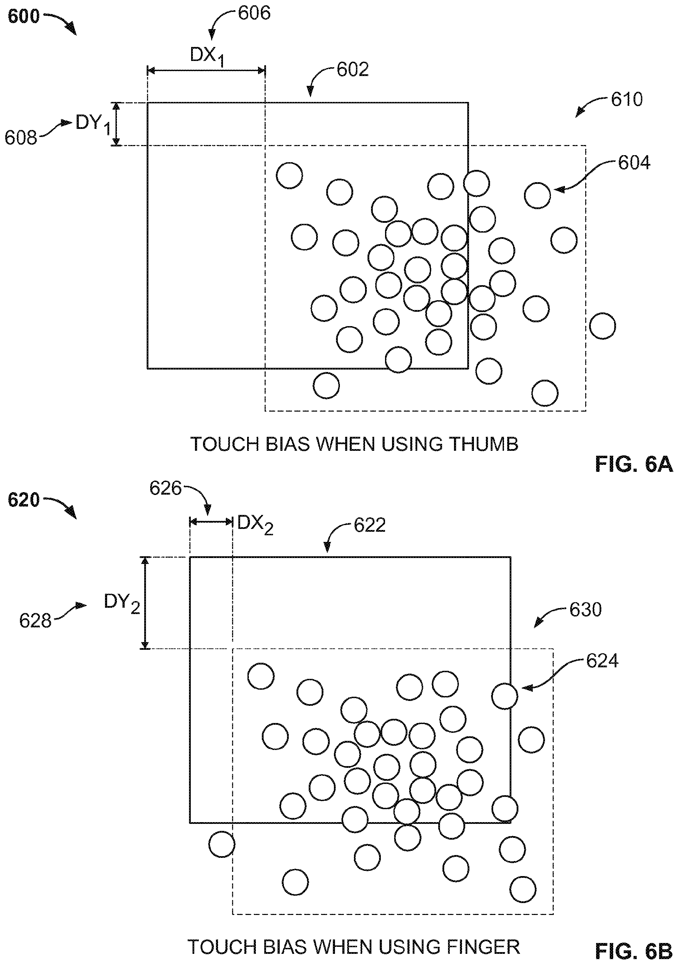

FIGS. 6A-E are diagrams depicting examples of touch bias on a touchscreen. FIG. 6A depicts a diagram 600 that shows an example touch bias for touch input from a right thumb when the user is holding a mobile computing device in his/her right hand. For a graphical element 602, touch input 604 is biased to the right (ΔX₁ 606) and down (ΔY₁ 608) of the graphical element 602. Correcting touch input from the user's right thumb (when holding the mobile device in the user's right hand) by the touch bias (ΔX₁ 606 and ΔY₁ 608) causes the majority of touch input 604 to fall with in a bias corrected graphical element 610 for the graphical element 602.

Similar to the diagram 600, FIG. 6B depicts a diagram 620 that shows an example touch bias for touch input from a right index finger when the user is holding a mobile computing device in his/her left hand. For a graphical element 622, touch input 624 is biased to the right (ΔX₂ 626) and down (ΔY₂ 628) of the graphical element 622. Correcting touch input from the user's right index finger (when holding the mobile device in the user's left hand) by the touch bias (ΔX₂ 626 and ΔY₂ 628) causes the majority of touch input 624 to fall with in a bias corrected graphical element 630 for the graphical element 622.

As indicated by the juxtaposition of FIGS. 6A-B, the touch bias associated with a finger can vary. For instance, the touch bias associated with the user's right index finger (ΔX₂ 626 and ΔY₂ 628) is depicted as being less than the touch bias associated with the user's right thumb (ΔX₁ 606 and ΔY₁ 608).

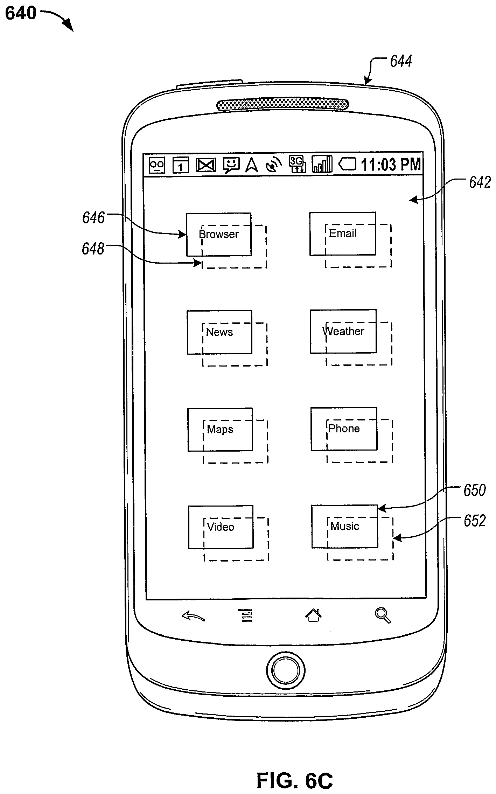

FIG. 6C depicts a diagram 640 of an example touch bias that is uniform across a touchscreen 642 of a mobile computing device 644. For instance, a bias correction applied to a graphical element 646 (resulting in a bias corrected graphical element 648) is depicted as being substantially the same as a bias correction applied to a graphical element 650 (resulting in a bias corrected graphical element 652). A uniform touch bias may be used in a variety of situations, such as when the identified finger or type of finger has a point of origin that is independent of the mobile computing device 644.

For example, when a user is holding the mobile computing device 644 with his/her left hand and touching the touchscreen 642 with his/her right index finger, the point of origin for the right index finger is independent of the mobile computing device 644 based on the user's right hand not holding the device 644. In contrast, were the user to be touching the device 644 with his/her left thumb while still holding the device with his/her left hand, the point of origin for the left thumb in this instance would not be independent of the device 644 - the point of origin for the left thumb is more or less fixed near the lower-left corner of the device 644.

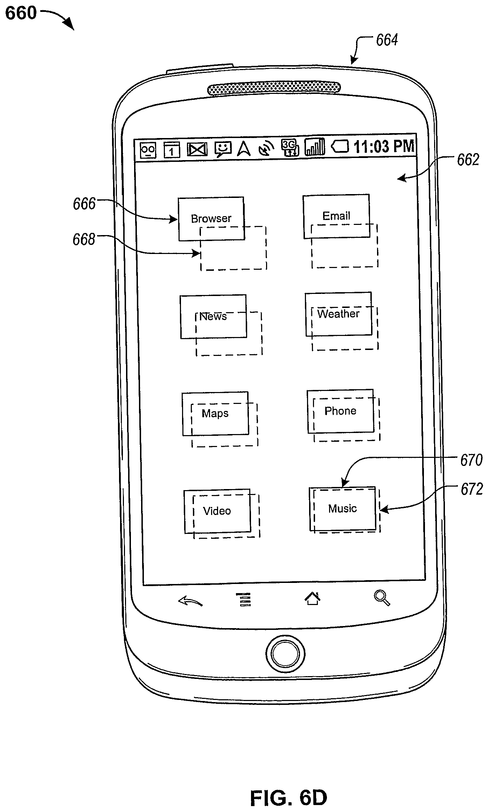

FIG. 6D depicts a diagram 660 of an example touch bias that is non-uniform across a touchscreen 662 of a mobile computing device 664. For instance, a bias correction applied to a graphical element 666 (resulting in a bias corrected graphical element 668) is depicted as being greater than a bias correction applied to a graphical element 670 (resulting in a bias corrected graphical element 672). A non-uniform touch bias may be used in a variety of situations, such as when the identified finger or type of finger has a point of origin that is not independent of the mobile computing device 644. For instance, the non-uniform distribution of touch bias depicted in the diagram 660 may result from the user touching the touchscreen 662 using his/her right thumb when holding the device 664 in his/her right hand. The graphical element furthest away from the point of origin (graphical element 666) can be associated with the greatest touch bias and the graphical element closest to the point of origin (graphical element 670) can be associated with the smallest touch bias.

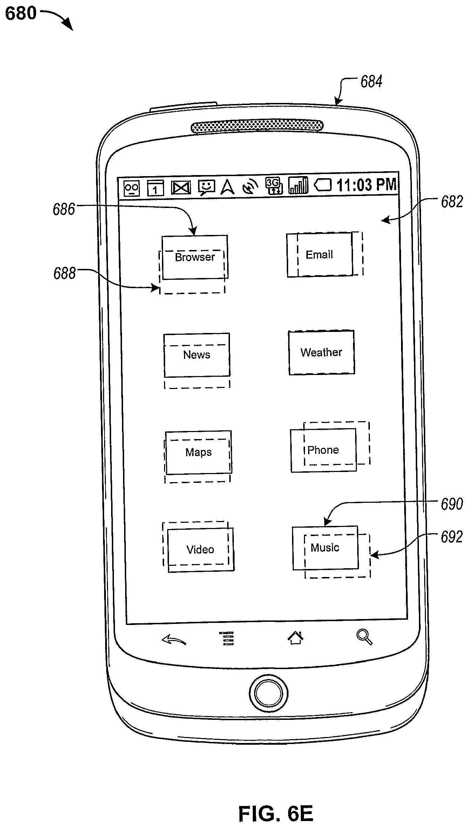

FIG. 6E depicts a diagram 680 of another example touch bias that is non-uniform across a touchscreen 682 of a mobile computing device 684. For instance, a bias correction applied to a graphical element 686 (resulting in a bias corrected graphical element 688) is depicted as being different in size and direction than a bias correction applied to a graphical element 690 (resulting in a bias corrected graphical element 692). A non-uniform bias correction of this type may be applied in a variety of situations, such as each graphical element (e.g., graphical elements 686 and 690) having an independent touch bias, as described with regard to FIG. 5B above.

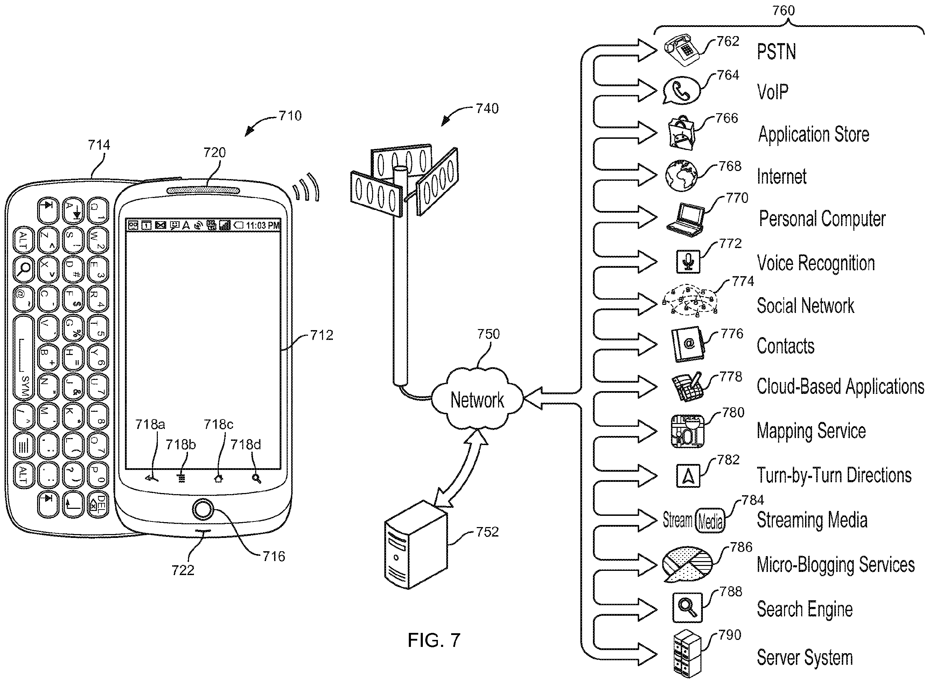

Referring now to FIG. 7, a conceptual diagram of a system that may be used to implement the systems and methods described in this document is illustrated. Mobile computing device 710 can wirelessly communicate with base station 740, which can provide the mobile computing device wireless access to numerous services 760 through a network 750.

In this illustration, the mobile computing device 710 is depicted as a handheld mobile telephone (e.g., a smartphone or an application telephone) that includes a touchscreen display device 712 for presenting content to a user of the mobile computing device 710. The mobile computing device 710 includes various input devices (e.g., keyboard 714 and touchscreen display device 712) for receiving user-input that influences the operation of the mobile computing device 710. In further implementations, the mobile computing device 710 may be a laptop computer, a tablet computer, a personal digital assistant, an embedded system (e.g., a car navigation system), a desktop computer, or a computerized workstation.

The mobile computing device 710 may include various visual, auditory, and tactile user-output mechanisms. An example visual output mechanism is display device 712, which can visually display video, graphics, images, and text that combine to provide a visible user interface. For example, the display device 712 may be a 3.7 inch AMOLED screen. Other visual output mechanisms may include LED status lights (e.g., a light that blinks when a voicemail has been received).

An example tactile output mechanism is a small electric motor that is connected to an unbalanced weight to provide a vibrating alert (e.g., to vibrate in order to alert a user of an incoming telephone call or confirm user contact with the touchscreen 712). Further, the mobile computing device 710 may include one or more speakers 720 that convert an electrical signal into sound, for example, music, an audible alert, or voice of an individual in a telephone call.

An example mechanism for receiving user-input includes keyboard 714, which may be a full qwerty keyboard or a traditional keypad that includes keys for the digits '0-7', '*', and '#.' The keyboard 714 receives input when a user physically contacts or depresses a keyboard key. User manipulation of a trackball 716 or interaction with a trackpad enables the user to supply directional and rate of rotation information to the mobile computing device 710 (e.g., to manipulate a position of a cursor on the display device 712).

The mobile computing device 710 may be able to determine a position of physical contact with the touchscreen display device 712 (e.g., a position of contact by a finger or a stylus). Using the touchscreen 712, various "virtual" input mechanisms may be produced, where a user interacts with a graphical user interface element depicted on the touchscreen 712 by contacting the graphical user interface element. An example of a "virtual" input mechanism is a "software keyboard," where a keyboard is displayed on the touchscreen and a user selects keys by pressing a region of the touchscreen 712 that corresponds to each key.

The mobile computing device 710 may include mechanical or touch sensitive buttons 718a-d. Additionally, the mobile computing device may include buttons for adjusting volume output by the one or more speakers 720, and a button for turning the mobile computing device on or off. A microphone 722 allows the mobile computing device 710 to convert audible sounds into an electrical signal that may be digitally encoded and stored in computer-readable memory, or transmitted to another computing device. The mobile computing device 710 may also include a digital compass, an accelerometer, proximity sensors, and ambient light sensors.

An operating system may provide an interface between the mobile computing device's hardware (e.g., the input/output mechanisms and a processor executing instructions retrieved from computer-readable medium) and software. Example operating systems include the ANDROID mobile device platform; APPLE IPHONE/MAC OS X operating systems; MICROSOFT WINDOWS 7/WINDOWS MOBILE operating systems; SYMBIAN operating system; RIM BLACKBERRY operating system; PALM WEB operating system; a variety of UNIX-flavored operating systems; or a proprietary operating system for computerized devices. The operating system may provide a platform for the execution of application programs that facilitate interaction between the computing device and a user.

The mobile computing device 710 may present a graphical user interface with the touchscreen 712. A graphical user interface is a collection of one or more graphical interface elements and may be static (e.g., the display appears to remain the same over a period of time), or may be dynamic (e.g., the graphical user interface includes graphical interface elements that animate without user input).

A graphical interface element may be text, lines, shapes, images, or combinations thereof. For example, a graphical interface element may be an icon that is displayed on the desktop and the icon's associated text. In some examples, a graphical interface element is selectable with user-input. For example, a user may select a graphical interface element by pressing a region of the touchscreen that corresponds to a display of the graphical interface element. In some examples, the user may manipulate a trackball to highlight a single graphical interface element as having focus. User-selection of a graphical interface element may invoke a pre-defined action by the mobile computing device. In some examples, selectable graphical interface elements further or alternatively correspond to a button on the keyboard 704. User-selection of the button may invoke the pre-defined action.

In some examples, the operating system provides a "desktop" user interface that is displayed upon turning on the mobile computing device 710, activating the mobile computing device 710 from a sleep state, upon "unlocking" the mobile computing device 710, or upon receiving user-selection of the "home" button 718c. The desktop graphical interface may display several icons that, when selected with user-input, invoke corresponding application programs. An invoked application program may present a graphical interface that replaces the desktop graphical interface until the application program terminates or is hidden from view.

User-input may manipulate a sequence of mobile computing device 710 operations. For example, a single-action user input (e.g., a single tap of the touchscreen, swipe across the touchscreen, contact with a button, or combination of these at a same time) may invoke an operation that changes a display of the user interface. Without the user-input, the user interface may not have changed at a particular time. For example, a multi-touch user input with the touchscreen 712 may invoke a mapping application to "zoom-in" on a location, even though the mapping application may have by default zoomed-in after several seconds.

The desktop graphical interface can also display "widgets." A widget is one or more graphical interface elements that are associated with an application program that has been executed, and that display on the desktop content controlled by the executing application program. Unlike an application program, which may not be invoked until a user selects a corresponding icon, a widget's application program may start with the mobile telephone. Further, a widget may not take focus of the full display. Instead, a widget may only "own" a small portion of the desktop, displaying content and receiving touchscreen user-input within the portion of the desktop.

The mobile computing device 710 may include one or more location-identification mechanisms. A location-identification mechanism may include a collection of hardware and software that provides the operating system and application programs an estimate of the mobile telephone's geographical position. A location-identification mechanism may employ satellite-based positioning techniques, base station transmitting antenna identification, multiple base station triangulation, internet access point IP location determinations, inferential identification of a user's position based on search engine queries, and user-supplied identification of location (e.g., by "checking in" to a location).

The mobile computing device 710 may include other application modules and hardware. A call handling unit may receive an indication of an incoming telephone call and provide a user capabilities to answer the incoming telephone call. A media player may allow a user to listen to music or play movies that are stored in local memory of the mobile computing device 710. The mobile telephone 710 may include a digital camera sensor, and corresponding image and video capture and editing software. An internet browser may enable the user to view content from a web page by typing in an addresses corresponding to the web page or selecting a link to the web page.

The mobile computing device 710 may include an antenna to wirelessly communicate information with the base station 740. The base station 740 may be one of many base stations in a collection of base stations (e.g., a mobile telephone cellular network) that enables the mobile computing device 710 to maintain communication with a network 750 as the mobile computing device is geographically moved. The computing device 710 may alternatively or additionally communicate with the network 750 through a Wi-Fi router or a wired connection (e.g., Ethernet, USB, or FIREWIRE). The computing device 710 may also wirelessly communicate with other computing devices using BLUETOOTH protocols, or may employ an ad-hoc wireless network.

A service provider that operates the network of base stations may connect the mobile computing device 710 to the network 750 to enable communication between the mobile computing device 710 and other computerized devices that provide services 760. Although the services 760 may be provided over different networks (e.g., the service provider's internal network, the Public Switched Telephone Network, and the Internet), network 750 is illustrated as a single network. The service provider may operate a server system 752 that routes information packets and voice data between the mobile computing device 710 and computing devices associated with the services 760.

The network 750 may connect the mobile computing device 710 to the Public Switched Telephone Network (PSTN) 762 in order to establish voice or fax communication between the mobile computing device 710 and another computing device. For example, the service provider server system 752 may receive an indication from the PSTN 762 of an incoming call for the mobile computing device 710. Conversely, the mobile computing device 710 may send a communication to the service provider server system 752 initiating a telephone call with a telephone number that is associated with a device accessible through the PSTN 762.

The network 750 may connect the mobile computing device 710 with a Voice over Internet Protocol (VoIP) service 764 that routes voice communications over an IP network, as opposed to the PSTN. For example, a user of the mobile computing device 710 may invoke a VoIP application and initiate a call using the program. The service provider server system 752 may forward voice data from the call to a VoIP service, which may route the call over the internet to a corresponding computing device, potentially using the PSTN for a final leg of the connection.

An application store 766 may provide a user of the mobile computing device 710 the ability to browse a list of remotely stored application programs that the user may download over the network 750 and install on the mobile computing device 710. The application store 766 may serve as a repository of applications developed by third-party application developers. An application program that is installed on the mobile computing device 710 may be able to communicate over the network 750 with server systems that are designated for the application program. For example, a VoIP application program may be downloaded from the Application Store 766, enabling the user to communicate with the VoIP service 764.

The mobile computing device 710 may access content on the internet 768 through network 750. For example, a user of the mobile computing device 710 may invoke a web browser application that requests data from remote computing devices that are accessible at designated universal resource locations. In various examples, some of the services 760 are accessible over the internet.

The mobile computing device may communicate with a personal computer 770. For example, the personal computer 770 may be the home computer for a user of the mobile computing device 710. Thus, the user may be able to stream media from his personal computer 770. The user may also view the file structure of his personal computer 770, and transmit selected documents between the computerized devices.

A voice recognition service 772 may receive voice communication data recorded with the mobile computing device's microphone 722, and translate the voice communication into corresponding textual data. In some examples, the translated text is provided to a search engine as a web query, and responsive search engine search results are transmitted to the mobile computing device 710.

The mobile computing device 710 may communicate with a social network 774. The social network may include numerous members, some of which have agreed to be related as acquaintances. Application programs on the mobile computing device 710 may access the social network 774 to retrieve information based on the acquaintances of the user of the mobile computing device. For example, an "address book" application program may retrieve telephone numbers for the user's acquaintances. In various examples, content may be delivered to the mobile computing device 710 based on social network distances from the user to other members. For example, advertisement and news article content may be selected for the user based on a level of interaction with such content by members that are "close" to the user (e.g., members that are "friends" or "friends of friends").

The mobile computing device 710 may access a personal set of contacts 776 through network 750. Each contact may identify an individual and include information about that individual (e.g., a phone number, an email address, and a birthday). Because the set of contacts is hosted remotely to the mobile computing device 710, the user may access and maintain the contacts 776 across several devices as a common set of contacts.

The mobile computing device 710 may access cloud-based application programs 778. Cloud-computing provides application programs (e.g., a word processor or an email program) that are hosted remotely from the mobile computing device 710, and may be accessed by the device 710 using a web browser or a dedicated program. Example cloud-based application programs include GOOGLE DOCS word processor and spreadsheet service, GOOGLE GMAIL webmail service, and PICASA picture manager.

Mapping service 780 can provide the mobile computing device 710 with street maps, route planning information, and satellite images. An example mapping service is GOOGLE MAPS. The mapping service 780 may also receive queries and return location-specific results. For example, the mobile computing device 710 may send an estimated location of the mobile computing device and a user-entered query for "pizza places" to the mapping service 780. The mapping service 780 may return a street map with "markers" superimposed on the map that identify geographical locations of nearby "pizza places."

Turn-by-turn service 782 may provide the mobile computing device 710 with turn-by-turn directions to a user-supplied destination. For example, the turn-by-turn service 782 may stream to device 710 a street-level view of an estimated location of the device, along with data for providing audio commands and superimposing arrows that direct a user of the device 710 to the destination.

Various forms of streaming media 784 may be requested by the mobile computing device 710. For example, computing device 710 may request a stream for a pre-recorded video file, a live television program, or a live radio program. Example services that provide streaming media include YOUTUBE and PANDORA.

A micro-blogging service 786 may receive from the mobile computing device 710 a user-input post that does not identify recipients of the post. The micro-blogging service 786 may disseminate the post to other members of the micro-blogging service 786 that agreed to subscribe to the user.

A search engine 788 may receive user-entered textual or verbal queries from the mobile computing device 710, determine a set of internet-accessible documents that are responsive to the query, and provide to the device 710 information to display a list of search results for the responsive documents. In examples where a verbal query is received, the voice recognition service 772 may translate the received audio into a textual query that is sent to the search engine.

These and other services may be implemented in a server system 790. A server system may be a combination of hardware and software that provides a service or a set of services. For example, a set of physically separate and networked computerized devices may operate together as a logical server system unit to handle the operations necessary to offer a service to hundreds of individual computing devices.

In various implementations, operations that are performed "in response" to another operation (e.g., a determination or an identification) are not performed if the prior operation is unsuccessful (e.g., if the determination was not performed). Features in this document that are described with conditional language may describe implementations that are optional. In some examples, "transmitting" from a first device to a second device includes the first device placing data into a network, but may not include the second device receiving the data. Conversely, "receiving" from a first device may include receiving the data from a network, but may not include the first device transmitting the data.

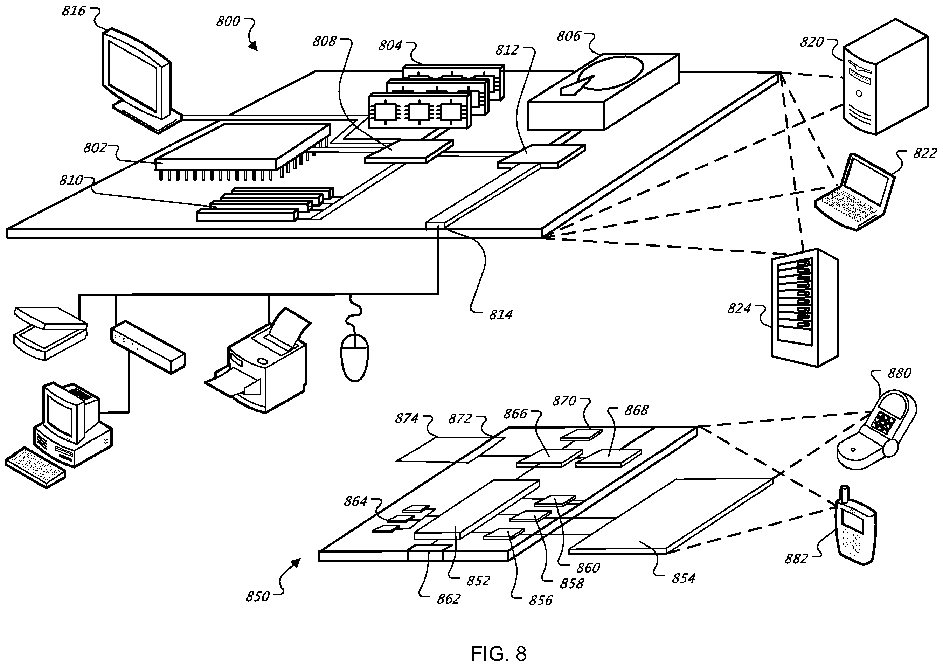

FIG. 8 is a block diagram of computing devices 800, 850 that may be used to implement the systems and methods described in this document, as either a client or as a server or plurality of servers. Computing device 800 is intended to represent various forms of digital computers, such as laptops, desktops, workstations, personal digital assistants, servers, blade servers, mainframes, and other appropriate computers. Computing device 850 is intended to represent various forms of mobile devices, such as personal digital assistants, cellular telephones, smartphones, and other similar computing devices. Additionally computing device 800 or 850 can include Universal Serial Bus (USB) flash drives. The USB flash drives may store operating systems and other applications. The USB flash drives can include input/output components, such as a wireless transmitter or USB connector that may be inserted into a USB port of another computing device. The components shown here, their connections and relationships, and their functions, are meant to be exemplary only, and are not meant to limit implementations described and/or claimed in this document.

Computing device 800 includes a processor 802, memory 804, a storage device 806, a high-speed interface 808 connecting to memory 804 and high-speed expansion ports 810, and a low speed interface 812 connecting to low speed bus 814 and storage device 806. Each of the components 802, 804, 806, 808, 810, and 812, are interconnected using various busses, and may be mounted on a common motherboard or in other manners as appropriate. The processor 802 can process instructions for execution within the computing device 800, including instructions stored in the memory 804 or on the storage device 806 to display graphical information for a GUI on an external input/output device, such as display 816 coupled to high speed interface 808. In other implementations, multiple processors and/or multiple buses may be used, as appropriate, along with multiple memories and types of memory. Also, multiple computing devices 800 may be connected, with each device providing portions of the necessary operations (e.g., as a server bank, a group of blade servers, or a multi-processor system).

The memory 804 stores information within the computing device 800. In one implementation, the memory 804 is a volatile memory unit or units. In another implementation, the memory 804 is a non-volatile memory unit or units. The memory 804 may also be another form of computer-readable medium, such as a magnetic or optical disk.

The storage device 806 is capable of providing mass storage for the computing device 800. In one implementation, the storage device 806 may be or contain a computer-readable medium, such as a floppy disk device, a hard disk device, an optical disk device, or a tape device, a flash memory or other similar solid state memory device, or an array of devices, including devices in a storage area network or other configurations. A computer program product can be tangibly embodied in an information carrier. The computer program product may also contain instructions that, when executed, perform one or more methods, such as those described above. The information carrier is a computer- or machine-readable medium, such as the memory 804, the storage device 806, or memory on processor 802.

The high speed controller 808 manages bandwidth-intensive operations for the computing device 800, while the low speed controller 812 manages lower bandwidth-intensive operations. Such allocation of functions is exemplary only. In one implementation, the high-speed controller 808 is coupled to memory 804, display 816 (e.g., through a graphics processor or accelerator), and to high-speed expansion ports 810, which may accept various expansion cards (not shown). In the implementation, low-speed controller 812 is coupled to storage device 806 and low-speed expansion port 814. The low-speed expansion port, which may include various communication ports (e.g., USB, Bluetooth, Ethernet, wireless Ethernet) may be coupled to one or more input/output devices, such as a keyboard, a pointing device, a scanner, or a networking device such as a switch or router, e.g., through a network adapter.

The computing device 800 may be implemented in a number of different forms, as shown in the figure. For example, it may be implemented as a standard server 820, or multiple times in a group of such servers. It may also be implemented as part of a rack server system 824. In addition, it may be implemented in a personal computer such as a laptop computer 822. Alternatively, components from computing device 800 may be combined with other components in a mobile device (not shown), such as device 850. Each of such devices may contain one or more of computing device 800, 850, and an entire system may be made up of multiple computing devices 800, 850 communicating with each other.

Computing device 850 includes a processor 852, memory 864, an input/output device such as a display 854, a communication interface 866, and a transceiver 868, among other components. The device 850 may also be provided with a storage device, such as a microdrive or other device, to provide additional storage. Each of the components 850, 852, 864, 854, 866, and 868, are interconnected using various buses, and several of the components may be mounted on a common motherboard or in other manners as appropriate.

The processor 852 can execute instructions within the computing device 850, including instructions stored in the memory 864. The processor may be implemented as a chipset of chips that include separate and multiple analog and digital processors. Additionally, the processor may be implemented using any of a number of architectures. For example, the processor 410 may be a CISC (Complex Instruction Set Computers) processor, a RISC (Reduced Instruction Set Computer) processor, or a MISC (Minimal Instruction Set Computer) processor. The processor may provide, for example, for coordination of the other components of the device 850, such as control of user interfaces, applications run by device 850, and wireless communication by device 850.

Processor 852 may communicate with a user through control interface 858 and display interface 856 coupled to a display 854. The display 854 may be, for example, a TFT (Thin-Film-Transistor Liquid Crystal Display) display or an OLED (Organic Light Emitting Diode) display, or other appropriate display technology. The display interface 856 may comprise appropriate circuitry for driving the display 854 to present graphical and other information to a user. The control interface 858 may receive commands from a user and convert them for submission to the processor 852. In addition, an external interface 862 may be provide in communication with processor 852, so as to enable near area communication of device 850 with other devices. External interface 862 may provide, for example, for wired communication in some implementations, or for wireless communication in other implementations, and multiple interfaces may also be used.

The memory 864 stores information within the computing device 850. The memory 864 can be implemented as one or more of a computer-readable medium or media, a volatile memory unit or units, or a non-volatile memory unit or units. Expansion memory 874 may also be provided and connected to device 850 through expansion interface 872, which may include, for example, a SIMM (Single In Line Memory Module) card interface. Such expansion memory 874 may provide extra storage space for device 850, or may also store applications or other information for device 850. Specifically, expansion memory 874 may include instructions to carry out or supplement the processes described above, and may include secure information also. Thus, for example, expansion memory 874 may be provide as a security module for device 850, and may be programmed with instructions that permit secure use of device 850. In addition, secure applications may be provided via the SIMM cards, along with additional information, such as placing identifying information on the SIMM card in a non-hackable manner.

The memory may include, for example, flash memory and/or NVRAM memory, as discussed below. In one implementation, a computer program product is tangibly embodied in an information carrier. The computer program product contains instructions that, when executed, perform one or more methods, such as those described above. The information carrier is a computer- or machine-readable medium, such as the memory 864, expansion memory 874, or memory on processor 852 that may be received, for example, over transceiver 868 or external interface 862..

Device 850 may communicate wirelessly through communication interface 866, which may include digital signal processing circuitry where necessary. Communication interface 866 may provide for communications under various modes or protocols, such as GSM voice calls, SMS, EMS, or MMS messaging, CDMA, TDMA, PDC, WCDMA, CDMA2000, or GPRS, among others. Such communication may occur, for example, through radio-frequency transceiver 868. In addition, short-range communication may occur, such as using a Bluetooth, WiFi, or other such transceiver (not shown). In addition, GPS (Global Positioning System) receiver module 870 may provide additional navigation- and location-related wireless data to device 850, which may be used as appropriate by applications running on device 850.

Device 850 may also communicate audibly using audio codec 860, which may receive spoken information from a user and convert it to usable digital information. Audio codec 860 may likewise generate audible sound for a user, such as through a speaker, e.g., in a handset of device 850. Such sound may include sound from voice telephone calls, may include recorded sound (e.g., voice messages, music files, etc.) and may also include sound generated by applications operating on device 850.

The computing device 850 may be implemented in a number of different forms, as shown in the figure. For example, it may be implemented as a cellular telephone 880. It may also be implemented as part of a smartphone 882, personal digital assistant, or other similar mobile device.

Various implementations of the systems and techniques described here can be realized in digital electronic circuitry, integrated circuitry, specially designed ASICs (application specific integrated circuits), computer hardware, firmware, software, and/or combinations thereof. These various implementations can include implementation in one or more computer programs that are executable and/or interpretable on a programmable system including at least one programmable processor, which may be special or general purpose, coupled to receive data and instructions from, and to transmit data and instructions to, a storage system, at least one input device, and at least one output device.

These computer programs (also known as programs, software, software applications or code) include machine instructions for a programmable processor, and can be implemented in a high-level procedural and/or object-oriented programming language, and/or in assembly/machine language. As used herein, the terms "machine-readable medium" "computer-readable medium" refers to any computer program product, apparatus and/or device (e.g., magnetic discs, optical disks, memory, Programmable Logic Devices (PLDs)) used to provide machine instructions and/or data to a programmable processor, including a machine-readable medium that receives machine instructions as a machine-readable signal. The term "machine-readable signal" refers to any signal used to provide machine instructions and/or data to a programmable processor.

To provide for interaction with a user, the systems and techniques described here can be implemented on a computer having a display device (e.g., a CRT (cathode ray tube) or LCD (liquid crystal display) monitor) for displaying information to the user and a keyboard and a pointing device (e.g., a mouse or a trackball) by which the user can provide input to the computer. Other kinds of devices can be used to provide for interaction with a user as well; for example, feedback provided to the user can be any form of sensory feedback (e.g., visual feedback, auditory feedback, or tactile feedback); and input from the user can be received in any form, including acoustic, speech, or tactile input.

The systems and techniques described here can be implemented in a computing system that includes a back end component (e.g., as a data server), or that includes a middleware component (e.g., an application server), or that includes a front end component (e.g., a client computer having a graphical user interface or a Web browser through which a user can interact with an implementation of the systems and techniques described here), or any combination of such back end, middleware, or front end components. The components of the system can be interconnected by any form or medium of digital data communication (e.g., a communication network). Examples of communication networks include a local area network ("LAN"), a wide area network ("WAN"), peer-to-peer networks (having ad-hoc or static members), grid computing infrastructures, and the Internet.

The computing system can include clients and servers. A client and server are generally remote from each other and typically interact through a communication network. The relationship of client and server arises by virtue of computer programs running on the respective computers and having a client-server relationship to each other.

Although a few implementations have been described in detail above, other modifications are possible. Moreover, other mechanisms for interpreting touch input using an identified finger or type of finger may be used. In addition, the logic flows depicted in the figures do not require the particular order shown, or sequential order, to achieve desirable results. Other steps may be provided, or steps may be eliminated, from the described flows, and other components may be added to, or removed from, the described systems. Accordingly, other implementations are within the scope of the following claims.

## Claims

1. A computer-implemented method comprising:
receiving, at a mobile computing device (104), a first input that indicates a user touched a touchscreen display (102) of the mobile computing device (104) with a pointer;
determining a position of the mobile computing device (104) with respect to the user based on information other than information from the user's touching of the touchscreen display, wherein determining the position of the mobile computing device (104) with respect to the user comprises determining how the user is holding the mobile computing device (104);
determining a level of pressure with which the pointer touched the touchscreen display (102);
identifying the pointer as a particular finger or type of finger of the user based upon, at least, the determined position of the mobile computing device (104) with respect to the user and the determined level of pressure with which the pointer touched the touchscreen display (102); and
interpreting the received first input on the touchscreen display (102) of the mobile computing device (104) using the identified finger or type of finger.

2. The computer-implemented method of claim 1, wherein the information upon which determining the position of the mobile computing device is based includes, at least, information provided by one or more components of an input subsystem of the mobile computing device other than the touchscreen display.

3. The computer-implemented method of claim 1, wherein the user is determined to be holding the mobile computing device in the user's right hand, in the user's left hand, in both the user's right and left hands, or the user is determined to not be holding the mobile computing device.

4. The computer-implemented method of claim 3, wherein, when the user is determined to be holding the mobile computing device in one but not both of the user's hands, the pointer is identified as a thumb of the user's hand that is holding the mobile computing device or as a finger on the user's other hand that is not holding the mobile computing device,
wherein, when the pointer is identified as the thumb of the user's hand that is holding the mobile computing device, the received first input is interpreted as having a greater offset from an intended point of contact on the touchscreen display than when the pointer is identified as a finger on the user's other hand that is not holding the mobile computing device.

5. The computer-implemented method of claim 1, further comprising determining a contact area with which the pointer touched the touchscreen display.

6. The computer-implemented method of claim 1, further comprising accessing one or more models that each correspond to a finger or a type of finger; and
wherein the pointer is identified as the particular finger or type of finger using the one or more accessed models; further comprising:
receiving, at the mobile computing device, a second input provided by the user in response to interpretation of the first input using the identified finger or type of finger;
determining whether the pointer was correctly identified as the particular finger or type of finger using the one or more accessed models based on the second input; and
updating the one or more accessed models according to whether the pointer is determined to have been correctly identified as the particular finger or type of finger.

7. The computer-implemented method of claim 6, wherein, when the received second input causes the mobile computing device to undo or modify an action performed based on interpretation of the first input using the identified finger or type of finger, the second input is determined to indicate that the pointer was not correctly identified as the particular finger or type of finger.

8. The computer-implemented method of claim 6, wherein, when the received second input causes the mobile computing device to perform an action that does not undo or modify a previous action performed based on interpretation of the first input using the identified finger or type of finger, the second input is determined to indicate that the pointer was correctly identified as the particular finger or type of finger.

9. The computer-implemented method of claim 6, further comprising, when the mobile computing device is in a training mode, providing output on the mobile computing device that indicates the particular finger or type of finger has been identified from the first input and that asks the user whether identification of the particular finger or type of finger is correct; and
wherein the second input is received in response to the provided output and comprises a response from the user indicating whether identification is correct.

10. The computer-implemented method of claim 1, wherein interpreting the received first input using the identified finger or type of finger comprises interpreting the first input using an offset from an intended point of contact on the touchscreen display that is associated with the identified finger or type of finger;
wherein the offset applied for the identified finger or type of finger is not uniform across the touchscreen display such that the offset is greater when the user touches the touchscreen with the identified finger or type of finger at a first location on the touchscreen display than when the user touches the touchscreen with the identified finger or type of finger at a second location on the touchscreen display.

11. The computer-implemented method of claim 1, wherein interpreting the received first input using the identified finger or type of finger comprises performing an action on the mobile computing device that is associated with the identified finger or type of finger.

12. A system for interpreting touchscreen input on a mobile computing device, the system comprising:
a mobile computing device (104);
a touchscreen display (102) of the mobile computing device that is configured to receive input that indicates a user touched the touchscreen display with a pointer;
a position extraction module (226) of the mobile computing device that is configured to determine a position of the mobile computing device with respect to the user based on information other than information from the user's touching of the touchscreen display, wherein being configured to determine the position of the mobile computing device with respect to the user comprises being configured to determine how the user is holding the mobile computing device;
a pressure level extraction module (224), that is configured to determine a level of pressure with which the pointer touched the touchscreen display (102);
means for identifying the pointer as a particular finger or type of finger of the user based on, at least, the determined position of the mobile computing device with respect to the user and the determined level of pressure with which the pointer touched the touchscreen display; and
an input interpreter (234) of the mobile computing device that is configured to interpret the received input on the touchscreen display of the mobile computing device using the particular finger or type of finger identified by the means for identifying.

13. The system of claim 12, further comprising:
a housing of the mobile computing device that includes one or more capacitive touch sensors that are configured to measure where the user is touching the housing of the mobile computing device; and
wherein the position extraction module of the mobile computing device that is configured to determine the position of the mobile computing device with respect to the user is based on measurements from the capacitive touch sensors included in the housing.

## Patentansprüche

1. Computerimplementiertes Verfahren, umfassend:
Empfangen, an einem mobilen Computergerät (104), einer ersten Eingabe, die angibt, dass ein Benutzer eine Touchscreen-Anzeige (102) des mobilen Computergeräts (104) mit einem Zeiger berührt hat;
Ermitteln einer Position des mobilen Computergeräts (104) im Verhältnis zu dem Benutzer, basierend auf Informationen, die von den Informationen aus dem Berühren der Touchscreen-Anzeige durch den Benutzer verschieden sind, wobei das Ermitteln der Position des mobilen Computergeräts (104) im Verhältnis zu dem Benutzer das Ermitteln umfasst, wie der Benutzer das mobile Computergerät (104) hält;
Ermitteln eines Druckniveaus, mit dem der Zeiger die Touchscreen-Anzeige (102) berührt hat;
Identifizieren des Zeigers als bestimmter Finger oder bestimmte Art von Finger des Benutzers, zumindest basierend auf der ermittelten Position des mobilen Computergeräts (104) im Verhältnis zu dem Benutzer und dem ermittelten Druckniveau, mit dem der Zeiger die Touchscreen-Anzeige (102) berührt hat; und
Interpretieren der empfangenen ersten Eingabe auf der Touchscreen-Anzeige (102) des mobilen Computergeräts (104) unter Nutzung des identifizierten Fingers oder der identifizierten Art von Finger.

2. Computerimplementiertes Verfahren nach Anspruch 1, wobei die Informationen, auf denen das Ermitteln der Position des mobilen Computergeräts basiert, zumindest Informationen beinhalten, die durch eine oder mehrere Komponenten eines Eingabe-Subsystems des mobilen Computergeräts bereitgestellt werden, die von der Touchscreen-Anzeige verschieden sind.

3. Computerimplementiertes Verfahren nach Anspruch 1, wobei ermittelt wird, dass der Benutzer das mobile Computergerät in der rechten Hand des Benutzers, in der linken Hand des Benutzers oder sowohl in der rechten als auch der linken Hand des Benutzers hält, oder ermittelt wird, dass der Benutzer das mobile Computergerät nicht hält.

4. Computerimplementiertes Verfahren nach Anspruch 3, wobei der Zeiger, wenn ermittelt wird, dass der Benutzer das mobile Computergerät in einer, aber nicht in beiden Händen des Benutzers hält, als ein Daumen der Hand des Benutzers, die das mobile Computergerät hält, oder als ein Finger an der anderen Hand des Benutzers, die das mobile Computergerät nicht hält, identifiziert wird,
wobei die empfangene erste Eingabe, wenn der Zeiger als der Daumen der Hand des Benutzers identifiziert wird, die das mobile Computergerät hält, so interpretiert wird, dass sie einen größeren Versatz zu einem beabsichtigten Kontaktpunkt auf der Touchscreen-Anzeige aufweist als dann, wenn der Zeiger als ein Finger an der anderen Hand des Benutzers identifiziert wird, die das mobile Computergerät nicht hält.

5. Computerimplementiertes Verfahren nach Anspruch 1, ferner das Ermitteln eines Kontaktbereichs umfassend, mit dem der Zeiger die Touchscreen-Anzeige berührt hat.

6. Computerimplementiertes Verfahren nach Anspruch 1, ferner das Zugreifen auf eines oder mehrere Modelle umfassend, die jeweils einem Finger oder einer Art von Finger entsprechen; und
wobei der Zeiger unter Nutzung des einen oder der mehreren Modelle, auf die zugegriffen wurde, als der bestimmte Finger oder die bestimmte Art von Finger identifiziert wird; ferner umfassend:
Empfangen, an dem mobilen Computergerät, einer zweiten Eingabe, die in Reaktion auf die Interpretation der ersten Eingabe durch den Benutzer unter Nutzung des identifizierten Fingers oder der identifizierten Art von Finger bereitgestellt wird;
Ermitteln, basierend auf der zweiten Eingabe, ob der Zeiger unter Nutzung des einen oder der mehreren Modelle, auf die zugegriffen wurde, korrekt als der bestimmte Finger oder die bestimmte Art von Finger identifiziert wurde; und
Aktualisieren des einen oder der mehreren Modelle, auf die zugegriffen wurde, in Abhängigkeit davon, ob ermittelt wird, dass der Zeiger korrekt als der bestimmte Finger oder die bestimmte Art von Finger identifiziert wurde.

7. Computerimplementiertes Verfahren nach Anspruch 6, wobei, wenn die empfangene zweite Eingabe das mobile Computergerät dazu veranlasst, eine auf einer Interpretation der ersten Eingabe unter Nutzung des identifizierten Fingers oder der identifizierten Art von Finger basierend durchgeführte Aktion rückgängig zu machen oder zu modifizieren, ermittelt wird, dass die zweite Eingabe angibt, dass der Zeiger nicht korrekt als der bestimmte Finger oder die bestimmte Art von Finger identifiziert wurde.

8. Computerimplementiertes Verfahren nach Anspruch 6, wobei, wenn die empfangene zweite Eingabe das mobile Computergerät dazu veranlasst, eine Handlung durchzuführen, die eine vorherige auf einer Interpretation der ersten Eingabe unter Nutzung des identifizierten Fingers oder der identifizierten Art von Finger basierend durchgeführte Aktion nicht rückgängig macht oder modifiziert, ermittelt wird, dass die zweite Eingabe angibt, dass der Zeiger korrekt als der bestimmte Finger oder die bestimmte Art von Finger identifiziert wurde.

9. Computerimplementiertes Verfahren nach Anspruch 6, ferner, wenn das mobile Computergerät sich in einem Trainingsmodus befindet, das Bereitstellen von Ausgaben auf dem mobilen Computergerät umfassend, die angeben, dass der bestimmte Finger oder die bestimmte Art von Finger aus der ersten Eingabe identifiziert wurde, und die den Benutzer fragen, ob die Identifikation des bestimmten Fingers oder der bestimmten Art von Finger korrekt ist; und
wobei die zweite Eingabe in Reaktion auf die bereitgestellten Ausgaben empfangen wird und eine Reaktion des Benutzers umfasst, die angibt, ob die Identifikation korrekt ist.

10. Computerimplementiertes Verfahren nach Anspruch 1, wobei das Interpretieren der empfangenen ersten Eingabe unter Nutzung des identifizierten Fingers oder der identifizierten Art von Finger das Interpretieren der ersten Eingabe unter Nutzung eines mit dem identifizierten Finger oder der identifizierten Art von Finger assoziierten Versatzes von einem beabsichtigten Kontaktpunkt auf der Touchscreen-Anzeige umfasst;
wobei der für den identifizierten Finger oder die identifizierte Art von Finger angewendete Versatz über die Touchscreen-Anzeige hinweg nicht einheitlich ist, sodass der Versatz größer ist, wenn der Benutzer den Touchscreen mit dem identifizierten Finger oder der identifizierten Art von Finger an einer ersten Stelle auf der Touchscreen-Anzeige berührt, als wenn der Benutzer den Touchscreen mit dem identifizierten Finger oder der identifizierten Art von Finger an einer zweiten Stelle auf der Touchscreen-Anzeige berührt.

11. Computerimplementiertes Verfahren nach Anspruch 1, wobei das Interpretieren der empfangenen ersten Eingabe unter Nutzung des identifizierten Fingers oder der identifizierten Art von Finger das Durchführen einer Aktion auf dem mobilen Computergerät umfasst, die mit dem identifizierten Finger oder der identifizierten Art von Finger assoziiert ist.

12. System zum Interpretieren von Touchscreen-Eingaben auf einem mobilen Computergerät, das System umfassend:
ein mobiles Computergerät (104);
eine Touchscreen-Anzeige (102) des mobilen Computergeräts, die dazu konfiguriert ist, Eingaben zu empfangen, die angeben, dass ein Benutzer die Touchscreen-Anzeige mit einem Zeiger berührt hat;
ein Positionsextraktionsmodul (226) des mobilen Computergeräts, das dazu konfiguriert ist, basierend auf Informationen, die von den Informationen aus dem Berühren der Touchscreen-Anzeige durch den Benutzer verschieden sind, eine Position des mobilen Computergeräts im Verhältnis zu dem Benutzer zu ermitteln, wobei die Konfiguration zum Ermitteln der Position des mobilen Computergeräts im Verhältnis zu dem Benutzer die Konfiguration zum Ermitteln umfasst, wie der Benutzer das mobile Computergerät hält;
ein Druckniveauextraktionsmodul (224), das dazu konfiguriert ist, ein Druckniveau zu ermitteln, mit dem der Zeiger die Touchscreen-Anzeige (102) berührt hat;
Mittel zum Identifizieren des Zeigers als ein bestimmter Finger oder eine bestimmte Art von Finger des Benutzers, zumindest basierend auf der ermittelten Position des mobilen Computergeräts im Verhältnis zu dem Benutzer und dem ermittelten Druckniveau, mit dem der Zeiger die Touchscreen-Anzeige berührt hat; und
ein Eingabeauswerter (234) des mobilen Computergeräts, der dazu konfiguriert ist, die auf der Touchscreen-Anzeige des mobilen Computergeräts empfangenen Eingaben unter Nutzung des bestimmten Fingers oder der bestimmten Art von Finger, der/die durch die Mittel zum Identifizieren identifiziert wurde, zu interpretieren.

13. System nach Anspruch 12, ferner umfassend:
ein Gehäuse des mobilen Computergeräts, das einen oder mehrere kapazitive Berührungssensoren beinhaltet, die dazu konfiguriert sind zu messen, wo der Benutzer das Gehäuse des mobilen Computergeräts berührt; und
wobei das Positionsextraktionsmodul des mobilen Computergeräts, das dazu konfiguriert ist, die Position des mobilen Computergeräts im Verhältnis zu dem Benutzer zu ermitteln, auf Messungen der kapazitiven Berührungssensoren basiert, die in dem Gehäuse enthalten sind.

## Revendications

1. Procédé mis en œuvre par ordinateur, comprenant :
la réception, au niveau d'un dispositif informatique mobile (104), d'une première entrée indiquant qu'un utilisateur a touché un affichage à écran tactile (102) du dispositif informatique mobile (104) avec un pointeur ;
la détermination d'une position du dispositif informatique mobile (104) par rapport à l'utilisateur sur la base d'informations autres que les informations issues du fait que l'utilisateur touche l'affichage à écran tactile, dans lequel la détermination de la position du dispositif informatique mobile (104) par rapport à l'utilisateur comprend la détermination de la manière dont l'utilisateur tient le dispositif informatique mobile (104) ;
la détermination d'un niveau de pression avec lequel le pointeur a touché l'affichage à écran tactile (102) ;
l'identification du pointeur comme un doigt ou type de doigt particulier de l'utilisateur basée sur, au moins, la position déterminée du dispositif informatique mobile (104) par rapport à l'utilisateur et le niveau déterminé de pression avec lequel le pointeur a touché l'affichage à écran tactile (102) ; et
l'interprétation de la première entrée reçue sur l'affichage à écran tactile (102) du dispositif informatique mobile (104) en utilisant le doigt ou type de doigt identifié.

2. Procédé mis en œuvre par ordinateur selon la revendication 1, dans lequel les informations sur lesquelles la détermination de la position du dispositif informatique mobile est basée incluent, au moins, des informations fournies par un ou plusieurs composants d'un sous-système d'entrée du dispositif informatique mobile autre que l'affichage à écran tactile.

3. Procédé mis en œuvre par ordinateur selon la revendication 1, dans lequel l'utilisateur est déterminé comme tenant le dispositif informatique mobile dans la main droite de l'utilisateur, dans la main gauche de l'utilisateur, dans les mains droite et gauche de l'utilisateur, ou l'utilisateur est déterminé comme ne tenant pas le dispositif informatique mobile.

4. Procédé mis en œuvre par ordinateur selon la revendication 3, dans lequel, lorsque l'utilisateur est déterminé comme tenant le dispositif informatique mobile dans une seule des deux mains de l'utilisateur, le pointeur est identifié comme un pouce de la main de l'utilisateur qui tient le dispositif informatique mobile ou comme un doigt sur l'autre main de l'utilisateur qui ne tient pas le dispositif informatique mobile,
dans lequel, lorsque le pointeur est identifié comme étant le pouce de la main de l'utilisateur qui tient le dispositif informatique mobile, la première entrée reçue est interprétée comme ayant un décalage plus grand à partir d'un point de contact prévu sur l'affichage à écran tactile que lorsque le pointeur est identifié comme un doigt sur l'autre main de l'utilisateur qui ne tient pas le dispositif informatique mobile.

5. Procédé mis en œuvre par ordinateur selon la revendication 1, comprenant en outre la détermination d'une zone de contact avec laquelle le pointeur a touché l'affichage à écran tactile.

6. Procédé mis en œuvre par ordinateur selon la revendication 1, comprenant en outre la consultation d'un ou plusieurs modèles qui correspondent chacun à un doigt ou à un type de doigt ; et
dans lequel le pointeur est identifié comme le doigt ou type de doigt particulier en utilisant les un ou de plusieurs modèles qui ont été consultés, comprenant en outre :
la réception, au niveau du dispositif informatique mobile, d'une seconde entrée fournie par l'utilisateur en réponse à l'interprétation de la première entrée en utilisant le doigt ou type de doigt identifié ;
le fait de déterminer si le pointeur a été correctement identifié comme le doigt ou type de doigt particulier en utilisant les un ou plusieurs modèles consultés sur la base de la seconde entrée ; et
la mise à jour des un ou plusieurs modèles qui ont été consultés selon que le pointeur est déterminé ou non comme ayant été correctement identifié comme le doigt ou type de doigt particulier.

7. Procédé mis en œuvre par ordinateur selon la revendication 6, dans lequel, lorsque la seconde entrée reçue amène le dispositif informatique mobile à annuler ou à modifier une action exécuter sur la base d'une interprétation de la première entrée en utilisant le doigt ou type de doigt identifié, la seconde entrée est déterminée pour indiquer que le pointeur n'a pas été correctement identifié comme le doigt ou type de doigt particulier.

8. Procédé mis en œuvre par ordinateur selon la revendication 6, dans lequel, lorsque la seconde entrée reçue amène le dispositif informatique mobile à effectuer une action qui n'annule ou ne modifie pas une action précédente exécutée sur la base d'une interprétation de la première entrée en utilisant le doigt ou type de doigt identifié, la seconde entrée est déterminée pour indiquer que le pointeur a été correctement identifié comme le doigt ou type de doigt particulier.

9. Procédé mis en œuvre par ordinateur selon la revendication 6, comprenant en outre, lorsque le dispositif informatique mobile est en mode d'entraînement, la fourniture d'une sortie sur le dispositif informatique mobile qui indique que le doigt ou type de doigt particulier a été identifié à partir de la première entrée et qui demande à l'utilisateur si l'identification du doigt ou type de doigt particulier est correcte ; et
dans lequel la seconde entrée est reçue en réponse à la sortie fournie et comprend une réponse de l'utilisateur indiquant si l'identification est correcte.

10. Procédé mis en œuvre par ordinateur selon la revendication 1, dans lequel l'interprétation de la première entrée reçue en utilisant le doigt ou type de doigt identifié comprend l'interprétation de la première entrée en utilisant un décalage à partir d'un point de contact prévu sur l'affichage à écran tactile qui est associé au doigt ou type de doigt identifié ;
dans lequel le décalage appliqué pour le doigt ou type de doigt identifié n'est pas uniforme sur l'affichage à écran tactile de sorte que le décalage est plus grand lorsque l'utilisateur touche l'écran tactile avec le doigt ou type de doigt identifié au niveau d'un premier emplacement sur l'écran tactile que lorsque l'utilisateur touche l'écran tactile avec le doigt ou type de doigt identifié au niveau d'un second emplacement sur l'affichage à écran tactile.

11. Procédé mis en œuvre par ordinateur selon la revendication 1, dans lequel l'interprétation de la première entrée reçue en utilisant le doigt ou type de doigt identifié comprend l'exécution d'une action sur dispositif informatique mobile qui est associé au doigt ou type de doigt identifié.

12. Système d'interprétation d'une entrée d'écran tactile sur un dispositif informatique mobile, le système comprenant :
un dispositif informatique mobile (104) ;
un affichage à écran tactile (102) du dispositif informatique mobile configuré pour recevoir une entrée qui indique qu'un utilisateur a touché l'affichage à écran tactile avec un pointeur ;
un module d'extraction de position (226) du dispositif informatique mobile qui est configuré pour déterminer une position du dispositif informatique mobile par rapport à l'utilisateur sur la base d'informations autres que les informations issues du fait que l'utilisateur touche l'affichage à écran tactile, dans lequel le fait de configurer pour déterminer la position du dispositif informatique mobile par rapport à l'utilisateur comprend le fait de configurer pour déterminer la manière dont l'utilisateur tient le dispositif informatique mobile ;
un module d'extraction de niveau de pression (224), configuré pour déterminer un niveau de pression avec lequel le pointeur a touché l'affichage à écran tactile (102) ;
un moyen d'identifier le pointeur comme un doigt ou type de doigt particulier de l'utilisateur basé sur, au moins, la position déterminée du dispositif informatique mobile par rapport à l'utilisateur et le niveau déterminé de pression avec lequel le pointeur a touché l'affichage à écran tactile ; et
un interprète d'entrée (234) du dispositif informatique mobile configuré pour interpréter l'entrée reçue sur l'affichage à écran tactile du dispositif informatique mobile en utilisant le doigt ou type de doigt particulier identifié par le moyen d'identification.

13. Système selon la revendication 12, comprenant en outre :
un boîtier du dispositif informatique mobile qui inclut un ou plusieurs capteurs tactiles capacitifs configurés pour mesurer où l'utilisateur touche le boîtier du dispositif informatique mobile ; et
dans lequel le module d'extraction de position du dispositif informatique mobile configuré pour déterminer la position du dispositif informatique mobile par rapport à l'utilisateur est basé sur des mesures des capteurs tactiles capacitifs inclus dans le boîtier.
